(19) **Europäisches Patentamt**

**European Patent Office**

**Office européen des brevets**

(11) **EP 1 202 407 B1**

(12) **EUROPEAN PATENT SPECIFICATION**

(45) Date of publication and mention
of the grant of the patent:
**26.07.2006 Bulletin 2006/30**

(51) Int Cl.:
*H01S 5/12* (2006.01)  *H01S 3/30* (2006.01)

(21) Application number: **01114717.0**

(22) Date of filing: **21.06.2001**

(54) **Semiconductor laser device for use as a pumping light source**

Halbleiterlaservorrichtung zur Verwendung als Pumplichtquelle

Dispositif laser à semiconducteurs pour source de pompage optique

(84) Designated Contracting States:
**DE FR GB IT**

(30) Priority: **23.10.2000 JP 2000323118**

(43) Date of publication of application:
**02.05.2002 Bulletin 2002/18**

(73) Proprietor: **The Furukawa Electric Co., Ltd.**
**Chiyoda-ku**
**Tokyo 100-8322 (JP)**

(72) Inventors:
• **Tsukiji, Naoki**
**Chiyoda-ku,**
**Tokyo 100-8322 (JP)**
• **Yoshida, Junji**
**Chiyoda-ku,**
**Tokyo 100-8322 (JP)**
• **Funabashi, Masaki**
**Chiyoda-ku,**
**Tokyo 100-8322 (JP)**

(74) Representative: **Schwabe - Sandmair - Marx**
**Stuntzstrasse 16**
**81677 München (DE)**

(56) References cited:
**EP-A- 0 479 279**   **EP-A- 1 130 704**
**GB-A- 2 347 520**   **US-A- 5 111 475**

• **TAINEAU A ET AL: "MULTIPLE DISTIBUTED FEEDBACK OPERATION AT 1.55 MUM WITH UNIFORM OUTPUT POWERS IN A SINGLE LASER DIODE" APPLIED PHYSICS LETTERS, AMERICAN INSTITUTE OF PHYSICS. NEW YORK, US, vol. 75, no. 5, 2 August 1999 (1999-08-02), pages 600-602, XP000875501 ISSN: 0003-6951**
• **PATENT ABSTRACTS OF JAPAN vol. 016, no. 196 (E-1200), 12 May 1992 (1992-05-12) -& JP 04 029387 A (HITACHI LTD), 31 January 1992 (1992-01-31)**
• **PATENT ABSTRACTS OF JAPAN vol. 015, no. 033 (P-1158), 25 January 1991 (1991-01-25) -& JP 02 272432 A (NIPPON TELEGR & TELEPH CORP), 7 November 1990 (1990-11-07)**

**Description**

The present invention relates to a semiconductor laser device for use in a semiconductor laser module suitable as an excitation light source for a Raman amplification system.

DISCUSSION OF THE BACKGROUND

With the proliferation of multimedia features on the Internet in the recent years, there has arisen a demand for larger data transmission capacity for optical communication systems. Conventional optical communication systems transmitted data on a single optical fiber at a single wavelength of 1310 nm or 1550 nm which have reduced light absorption properties for optical fibers. However, in order to increase the data transmission capacity of such single fiber systems, it was necessary to increase the number of optical fibers laid on a transmission route which resulted in an undesirable increase in costs.

In view of this, there has recently been developed wavelength division multiplexing (WDM) optical communications systems such as the dense wavelength division multiplexing (DWDM) system wherein a plurality of optical signals of different wavelengths can be transmitted simultaneously through a single optical fiber. These systems generally use an Erbium Doped Fiber Amplifier (EDFA) to amplify the data light signals as required for long transmission distances. WDM systems using EDFA initially operated in the 1550 nm band which is the operating band of the Erbium Doped fiber Amplifier and the band at which gain flattening can be easily achieved. While use of WDM communication systems using the EDFA has recently expanded to the small gain coefficient band of 1580 nm, there has nevertheless been an increasing interest in an optical amplifier that operates outside the EDFA band because the low loss band of an optical fiber is wider than a band that can be amplified by the EDFA; a Raman amplifier is one such optical amplifier.

In a Raman amplifier system, a strong pumping light beam is pumped into an optical transmission line carrying an optical data signal. As is known in to one of ordinary skill in the art, a Raman scattering effect causes a gain for optical signals having a frequency approximately 13THz smaller than the frequency of the pumping beam. Where the data signal on the optical transmission line has this longer wavelength, the data signal is amplified. Thus, unlike an EDFA where a gain wavelength band is determined by the energy level of an Erbium ion, a Raman amplifier has a gain wavelength band that is determined by a wavelength of the pumping beam and, therefore, can amplify an arbitrary wavelength band by selecting a pumping light wavelength. Consequently, light signals within the entire low loss band of an optical fiber can be amplified with the WDM communication system using the Raman amplifier and the number of channels of signal light beams can be increased as compared with the communication system using the EDFA.

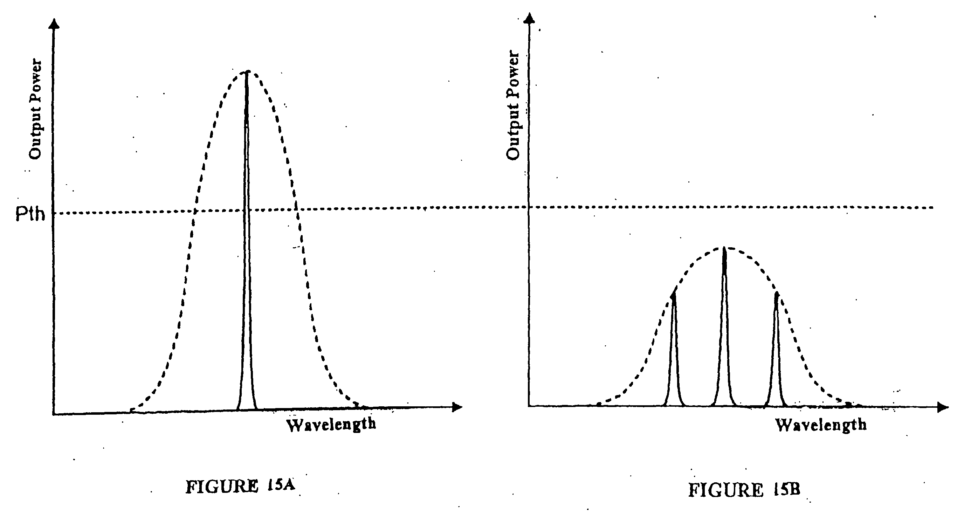

Although the Raman amplifier amplifies signals over a wide wavelength band, the gain of a Raman amplifier is relatively small and, therefore, it is preferable to use a high output laser device as a pumping source. However, merely increasing the output power of a single mode pumping source leads to undesirable stimulated Brillouin scattering and increased noises at high peak power values. Therefore, the Raman amplifier requires a pumping source laser beam having a plurality of oscillating longitudinal modes. As seen in Figures 15A and 15B, stimulated Brillouin scattering has a threshold value $P_{th}$ at which the stimulated Brillouin scattering is generated. For a pumping source having a single longitudinal mode as in the oscillation wavelength spectrum of Figure 15A, the high output requirement of a Raman amplifier, for example 300 mw, causes the peak output power of the single mode to be higher than $P_{th}$ thereby generating undesirable stimulated Brillouin scattering. On the other hand, a pumping source having multiple longitudinal modes distributes the output power over a plurality of modes each having relatively a low peak value. Therefore, as seen in Figure 15B, a multiple longitudinal mode pumping source having the required 300 mw output power can be acquired within the threshold value $P_{th}$ thereby eliminating the stimulated Brillouin scattering problem and providing a larger Raman gain.

In addition, because the amplification process in a Raman amplifier is quick to occur, when a pumping light intensity is unstable, a Raman gain is also unstable. These fluctuations in the Raman gain result in fluctuations in the intensity of an amplified signal which is undesirable for data communications. Therefore, in addition to providing multiple longitudinal modes, the pumping light source of a Raman amplifier must have relatively stable intensity.

Moreover, Raman amplification in the Raman amplifier occurs only for a component of signal light having the same polarization as a pumping light. That is, in the Raman amplification, since an amplification gain has dependency on a polarization, it is necessary to minimize an influence caused by the difference between a polarization of the signal light beam and that of a pumping light beam. While a backward pumping method causes no polarization problem because the difference in polarization state between the signal light and the counter-propagating pumping light is averaged during transmission, a forward pumping method has a strong dependency on a polarization of pumping light because the difference in polarization between the two co-propagating waves is preserved during transmission Therefore, where a forward pumping method is used, the dependency of Raman gain on a polarization of pumping light must be minimized by polarization-multiplexing of pumping light beams, depolarization, and other techniques for minimizing the degree of polarization (DOP). In this regard it is known that the multiple longitudinal modes provided by the pumping light source help to provide this minimum degree of polarization

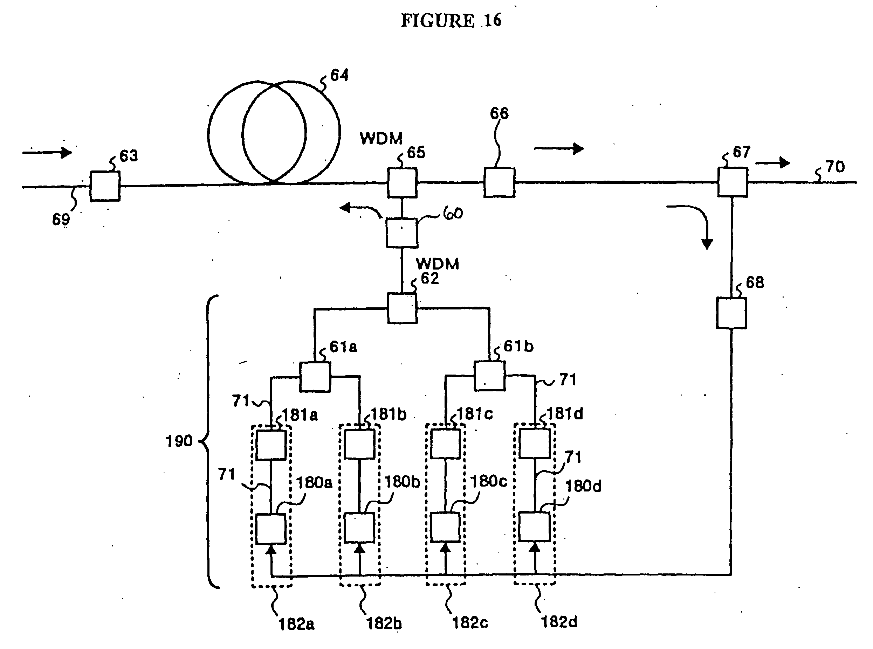

Figure 16 is a block diagram illustrating a configuration of the conventional Raman amplifier used in a WDM communication system. In Figure 16, semiconductor laser modules 182a through 182d, include paired Fabry-Pérot type semiconductor light-emitting elements 180a through 180d having fiber gratings 181 a through 181d respectively. The laser modules 182a and 182b output laser beams having the same wavelength via polarization maintaining fiber 71 to polarization-multiplexing coupler 61a Similarly the laser modules 182c and 182d output laser beams having the same wavelength via polarization maintaining fiber 71 to polarization-multiplexing coupler 61 b. Each polarization maintaining fiber 71 constitutes a single thread optical fiber which has a fiber grating 181 a-181 d inscribed on the fiber. The polarization-multiplexing couplers 61 a and 61 b respectively output the polarization-multiplexed laser beams to a WDM coupler 62. These laser beams outputted from the polarization-multiplexing couplers 61 a and 61 b have different wavelengths.

The WDM coupler 62 multiplexes the laser beams outputted from the polarization-multiplexing couplers 61 a and 61 b, and outputs the multiplexed light beams as a pumping light beam to external isolator 60, which outputs the beam to amplifying fiber 64 via WDM coupler 65. Signal light beams to be amplified are input to amplifying fiber 64 from signal light inputting fiber 69 via polarization-independent isolator 63. The amplified signal light beams are Raman-amplified by being multiplexed with the pumping light beams and input to a monitor light branching coupler 67 via the WDM coupler 65 and the polarization-independent isolator 66. The monitor light branching coupler 67 outputs a portion of the amplified signal light beams to a control circuit 68, and the remaining amplified signal light beams as an output laser beam to signal light outputting fiber 70. The control circuit 68 performs feedback control of a light-emitting state, such as, an optical intensity, of each of the semiconductor light-emitting elements 180a through 180d based on the portion of the amplified signal light beams input to the control circuit 68 such that the resulting Raman amplification gain is flat over wavelength.

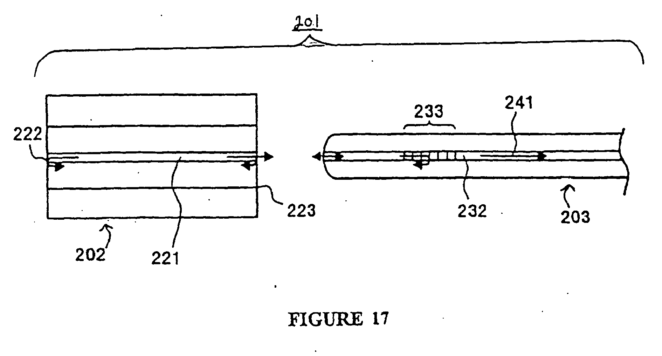

Figure 17 is an illustration showing a general configuration of a conventional fiber grating semiconductor laser module 182a -182d used in the conventional Raman amplifier system of Figure 16. As seen in Figure 17, semiconductor laser module 201 includes a semiconductor light-emitting element (laser diode) 202 and an optical fiber 203. The semiconductor light-emitting element 202 has an active layer 221 provided with a light reflecting surface 222 at one end thereof, and a light irradiating surface 223 at the other end. Light beams generated inside the active layer 221 are reflected on the light reflecting surface 222 and output from the light irradiating surface 223.

Optical fiber 203 is disposed on the light irradiating surface 223 of the semiconductor light-emitting element 222, and is optically coupled with the light irradiating surface 223. Fiber grating 233 is formed at a position of a predetermined distance from the light irradiating surface 223 in a core 232 of the optical fiber 203, and the fiber grating 233 selectively reflects light beams of a specific wavelength. That is, the fiber grating 233 functions as an external resonator between the fiber grating 233 and the light reflecting surface 222, and selects and amplifies a laser beam of a specific wavelength which is then output as an output laser beam 241.

While the conventional fiber grating semiconductor laser module 182a-182d provides the multiple longitudinal modes necessary for use in a Raman amplifier, the fiber grating module of Figure 17 is problematic in that it has a large value of relative intensity noise (RIN) which reflects large fluctuations in light intensity. As discussed above, this fluctuation in the pumping light intensity is undesirable for Raman amplification because it could generate a fluctuation in Raman gain which in turn causes the amplified signal to fluctuate. The large value RIN is especially undesirable for Raman amplifiers using a forward pumping method, where the signal light of weakened intensity and the pumping light of high intensity propagate in the same direction. Therefore, even though the conventional fiber grating laser module provides multiple longitudinal modes which allow a diminished degree of polarization as needed in a forward pumping method, the forward pumping method is not frequently used with the fiber grating module because of the high RIN of such module.

The mechanical structure of the fiber grating laser module also causes instability of the conventional pumping light source. Specifically, because the optical fiber 203 with fiber grating 233 is laser-welded to the package, mechanical vibration of the device or a slight shift of the optical fiber 203 with respect to the light emitting element 202 could cause a change in oscillating characteristics and, consequently, an unstable light source. This shift in the alignment of the optical fiber 203 and light emitting element 202 is generally caused by changes in ambient temperature. In this regard, such changes in ambient temperature also cause small changes in oscillation wavelength selected by the fiber grating 233, further contributing to instability of the pumping light source.

Yet another problem associated with the fiber grating laser module is the high loss caused by the need for an external isolator. In a laser module with a fiber grating, an isolator cannot be intervened between the semiconductor laser device and the optical fiber because the external cavity oscillation is governed by the reflection from the fiber grating. That is, the isolator would prevent the reflected light from the grating from returning to the semiconductor laser device. Therefore, the fiber grating laser module has a problem in that it is susceptible to reflection and easily influenced. Moreover, as seen in Figure 16, a Raman amplifier system using the fiber grating module must use external isolator 60. As is known in the art, this isolator presents a relatively high loss to the pumping light due to a connection the collecting lens and output fiber of the external isolator.

The European patent application No. 04 792 798.2 is directed to a distributed feedback semiconductor laser. This distributed semiconductor laser includes a diffraction grating having a plurality of different pitches. Although it is a multi mode laser, an oscillating mode having a longitudinal single mode characteristic is obtained. The distributed feedback semiconductor laser is thus free from nonlinear characteristics but has low-noise characteristics.

In the IEEE proceedings: "Optoelectronics", Institution of Electrical Engineers, Stevenage, Gb (15-02-2000), 147(1), 37 to 42, Hussein Murad et. al. have published an article with the title "Design and simulation of a dual mode semiconductor laser using sampled grating DFB structure". In this article, a dual mode laser source is proposed. It is based on a sampled grating DFB laser constituted with alternating DFB and FP sections. The basic principles of this device are presented, and its behaviour is studied through modelling. It is shown that mode spacing in the millimetre wave domain (here 60 GHz) can be achieved with relatively short devices using a common DFB structure coupling coefficient.

SUMMARY OF THE INVENTION

It is the object of the present invention is to provide a laser device and method for providing a light source suitable for use as a pumping light source in a Raman amplification system. The above identified problem is solved by the subject-matter of the independent claims. The dependent claims are directed to embodiments of advantage.

BRIEF DESCRIPTION OF THE DRAWINGS

A more complete appreciation of the invention and many of the attendant advantages thereof will be readily obtained as the same becomes better understood by reference to the following retailed description when considered in connection with the accompanying drawings, wherein:

Figure 1 is a broken perspective view showing a general configuration of a semiconductor laser device according to an embodiment of the present invention;

Figure 2 is a vertical sectional view in the longitudinal direction of the semiconductor laser device shown in Figure 1;

Figure 3 is a cross sectional view of the semiconductor laser device, taken along the line A-A of the semiconductor laser device shown in Figure 2;

Figure 4 is a graph showing the multiple oscillation longitudinal mode output characteristics of a diffraction grating semiconductor laser device of the present invention;

Figure 5 is a vertical sectional view in the longitudinal direction illustrating a semiconductor laser device having a shortened diffraction grating in the vicinity of an antireflection coating in according to an embodiment of the present invention;

Figure 5A is a graph showing the optical output power of a semiconductor laser device, as a function of oscillation wavelength, in accordance with an embodiment of the present invention;

Figure 6 is a vertical sectional view in the longitudinal direction illustrating a semiconductor laser device having a shortened diffraction grating in the vicinity of a reflection coating in according to an embodiment of the present invention;

Figure 7 is a vertical sectional view in the longitudinal direction illustrating a semiconductor laser device having a first shortened diffraction grating in the vicinity of a an antireflection coating and a second shortened diffraction grating in the vicinity of reflection coating in according to an embodiment of the present invention;

Figure 8 is a vertical sectional view in the longitudinal direction illustrating a general configuration of a semiconductor laser device having a chirped diffraction grating in accordance with an embodiment of the present invention;

Figure 9 is a graph illustrating the principle of a composite oscillation wavelength spectrum produced by the combined period $\Lambda_1$ and $\Lambda_2$ of Figure 8.

Figure 10 illustrates a periodic fluctuation of the grating period of a chirped diffraction grating;

Figures 11A through 11C illustrate examples for realizing the periodic fluctuation of the diffraction grating;

Figure 12 is a vertical sectional view illustrating a configuration of a semiconductor laser module;

Figure 13 is a block diagram illustrating a configuration of a Raman amplifier in which polarization dependency is canceled by polarization-multiplexing of pumping light beams output from two semiconductor laser devices;

Figure 13A is a block diagram illustrating a configuration of a Raman amplifier in which polarization dependency is canceled by depolarizing a pumping light beam output from a single semiconductor laser device using polarization maintaining fibers as a depolarizer.

Figure 14 is a block diagram illustrating a general configuration of a WDM communication system in which the Raman amplifier shown in Figure 13 is used;

Figures 15A and 15B are graphs showing the relationship of laser beam output powers with respect to a single oscillation longitudinal mode and a plurality of oscillation longitudinal modes, and a threshold value of the stimulated Brillouin scattering;

Figure 16 is a block diagram illustrating a general configuration of a conventional Raman amplifier; and Figure 17 is a diagram showing a configuration of a semiconductor laser module used in the Raman amplifier shown in Figure 16.

DETAILED DESCRIPTION OF THE PREFERRED EMBODIMENTS

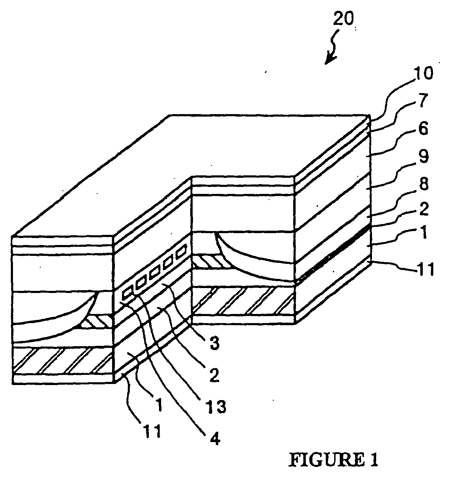

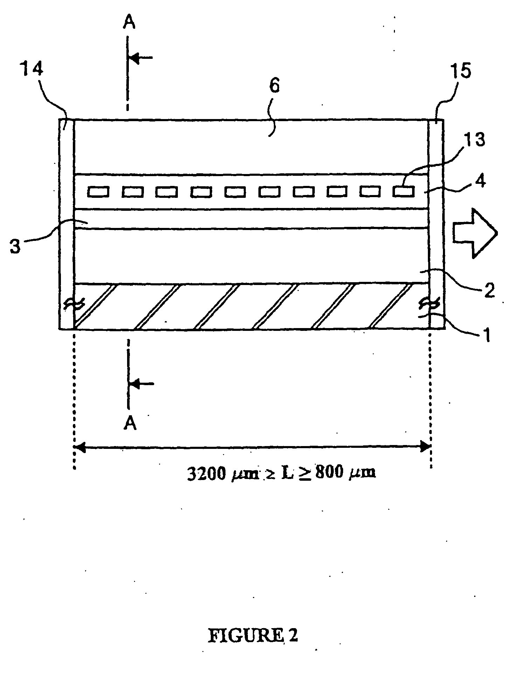

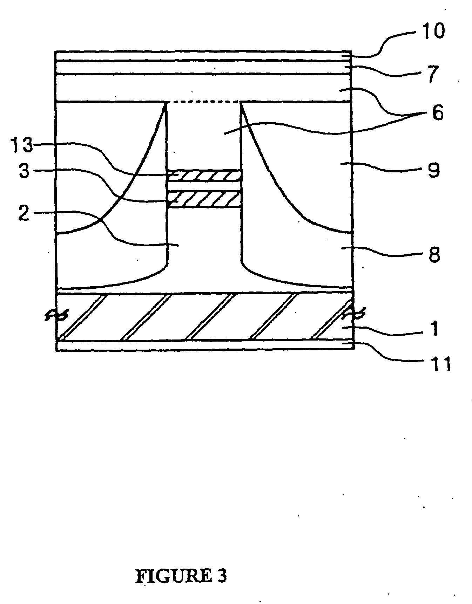

Referring now to the drawings wherein like elements are represented by the same reference designation throughout, and more particularly to Figures 1, 2 and 3 thereof, there is shown a semiconductor laser device for providing a light source suitable for use as a pumping light source in a Raman amplification system in accordance with an embodiment of the present invention. Figure 1 is a broken perspective view showing a general configuration of a semiconductor laser device according to an embodiment of the present invention. Figure 2 is a vertical sectional view in the longitudinal direction of the semiconductor laser device shown in Figure 1, and Figure 3 is a cross sectional view of the semiconductor laser device, taken along the line A-A in Figure 2.

The semiconductor laser device 20 of Figures 1-3 includes an n-InP substrate 1 having an n-InP buffer layer 2, an active layer 3, a p-InP spacer layer 4, a p-InP cladding layer 6, and an InGaAsP cap layer 7 sequentially stacked on the substrate 1. Buffer layer 2 serves both as a buffer layer by the n-InP material and a under cladding layer, while the active layer 3 is a graded index separate confinement multiple quantum well (GRIN-SCH-MQW). A diffraction grating 13 of a p-InGaAs material is periodically formed within the p-InP spacer layer 4 substantially along the entire length of active layer 3. The diffraction grating 13 of the embodiment of Figure 1 has a film thickness of 20 nm, a pitch of 220 nm, and selects a laser beam having a central wavelength of 1480 nm, to be emitted by the semiconductor laser device 20.

As best seen in Figure 3, the p-InP spacer layer 4 having the diffraction grating 13, the GRIN-SCH-MQW active layer 3, and the upper part of the n-InP buffer layer 2 are processed in a mesa strip shape. The sides of the mesa strip are buried by a p-InP blocking layer 8 and an n-InP blocking layer 9 formed as current blocking layers. In addition, a p-side electrode 10 is formed on the upper surface of InGaAsP cap layer 7, and an n-side electrode 11 is formed on the back surface of n-InP substrate 1.

As seen in Figure 2, reflective film 14 having high reflection factor of, for example, 80% or more is fonned on a light reflecting end surface that is one end surface in the longitudinal direction of the semiconductor laser device 20. Antireflection coating 15 having low light reflection factor of, for example, 1% to 5% is formed on a light irradiating end surface opposing the light reflecting end surface of semiconductor laser device 20. The reflective film 14 and the antireflection coating 15 form a light resonator within the active region 3 of the semiconductor laser device 20. As seen in Figure 2, the resonator has a predetermined length L as will be further described below. A light beam generated inside the GRIN-SCH-MQW active layer 3 of the light resonator is reflected by the reflective film 14 and irradiated as an output laser beam via the antireflection coating 15.

Thus, as seen in the embodiment of Figures 1-3, a diffraction grating is provided within the spacer layer 4 of the semiconductor laser device 20. The present inventors have realized that such an integrated diffraction grating contained within the semiconductor laser device provides several advantages over external fiber grating laser modules such as the one described with respect to Figure 17.

First, the semiconductor laser module illustrated in Figure 17 provides a light source with high RIN which is contrary to the requirements of a Raman amplifier as discussed above. Referring again to Figure 17, the present inventors have discovered that the fiber grating semiconductor laser module 201 (182a through 182d in Figure 16) has a large RIN due to resonance between the external fiber grating 233 and the light reflecting surface 222 of the semiconductor laser emitting element 202. That is, due to the long interval between the fiber grating 233 and the semiconductor light-emitting element 202, stable Raman amplification cannot be performed. However, since the semiconductor laser device 20 provides a laser beam irradiated from the low reflection coating 15 directly as an excitation light source of the Raman amplifier without using an external fiber grating, the RIN is smaller. As a result, the fluctuation of the Raman gain becomes smaller and a stable Raman amplification can be performed in systems using an integrated diffraction grating semiconductor laser device.

Moreover, because of the low RIN level, the integrated grating semiconductor laser device is not constrained to a backward pumping method when used in a Raman amplification system as with fiber grating semiconductor laser modules. Applicants have recognized that the backward pumping method is most frequently used in present fiber grating Raman amplifier systems because the forward pumping method, in which a weak signal light beam advances in the same direction as a strong excited light beam, has a problem in that fluctuation-associated noises of pumping light are easy to be modulated onto the signal. As discussed above, the semiconductor laser device provides a stable pumping light source for Raman amplification and therefore can easily be adapted to a forward pumping method.

The mechanical stability problems of the semiconductor laser module illustrated in Figure 17 are also diminished. Since the resonator of the diffraction grating device is not physically separated from the semiconductor laser device but monolithically integrated therein, the semiconductor laser device of this first embodiment does not experience a variation of the oscillating characteristic of a laser caused by mechanical vibration or change in ambient temperature and can acquire a stable light output and Raman gain. Moreover, as the diffraction grating of the present invention is internal to the semiconductor device, the temperature of the grating is controlled by the temperature control unit that provides temperature control for the semiconductor device. This not only eliminates the affects of ambient temperature changes on the oscillation wavelength selected by the grating, but also provides a mechanism for controlling the oscillation wavelength of a multiple mode laser device in accordance with the present invention as will be further described below.

While the integrated diffraction grating device of the present invention provides the above-described advantages over the fiber grating laser module, the primary use of the present invention is as a pumping source for a Raman amplifier. Therefore, the integrated diffraction grating device must also provide multiple longitudinal mode operation. Despite the fact that conventional integrated grating devices provided only single mode operation suitable for a signal light source, the present inventors have discovered that multiple mode operation suitable for a pumping light source for Raman amplification can be provided by an integrated diffraction grating device.

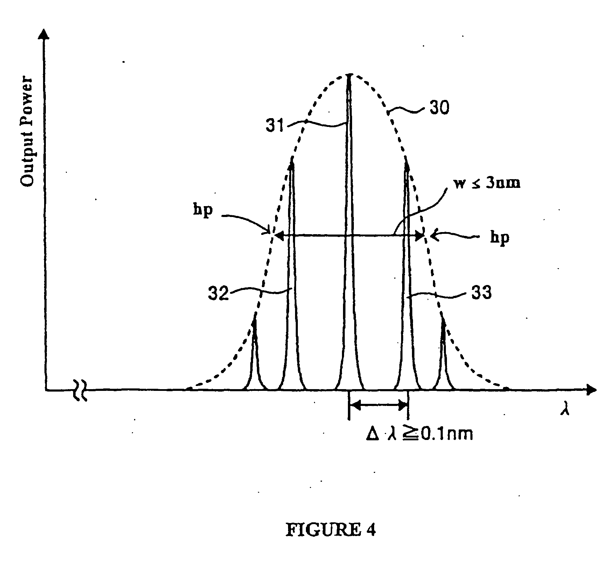

Figure 4 shows the multiple oscillation longitudinal mode output characteristics of a diffraction grating semiconductor laser device of the present invention. As seen in this figure, the oscillation wavelength spectrum 30 provides multiple longitudinal modes, for example 31, 32, and 33, separated by a wavelength interval $\Delta\lambda$. As the integrated diffraction grating of the laser device of the present invention selects a longitudinal mode by its Bragg wavelength, Figure 4 also shows the predetermined spectral width w of the oscillation spectrum 30 as defined by of half power points hp of the oscillation spectrum. The predetermined spectral width w is a predetermined spectral bandwidth which defines a portion of the wavelength oscillation spectrum that includes the laser operating modes. Thus, while Figure 4 shows the predetermined spectral width w as the full width at half maximum power (FWHM), it is to be understood that the predetermined spectral width w may be defined by any width on the oscillation spectrum 30. For example, another known way to define the predetermined spectral width is by the 10db down from maximum power points of the oscillation wavelength spectrum 30. It is clear from this description that the number of laser operating modes may change for a given oscillation wavelength spectrum depending on how the predetermined spectral width w is defined. Thus, as recognized by the present inventors, in order to provide the multiple oscillation longitudinal mode characteristics required to reduce stimulated Brillouin scattering in a Raman amplifier, an integrated difraction grating laser device must provide a plurality of oscillation longitudinal modes within the predetermined spectral width w of the oscillation wavelength spectrum 30.

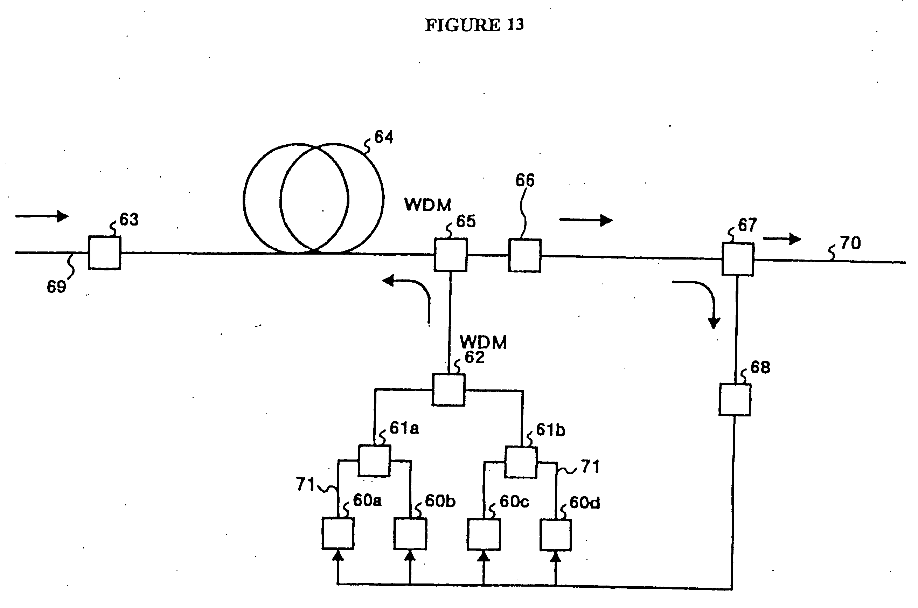

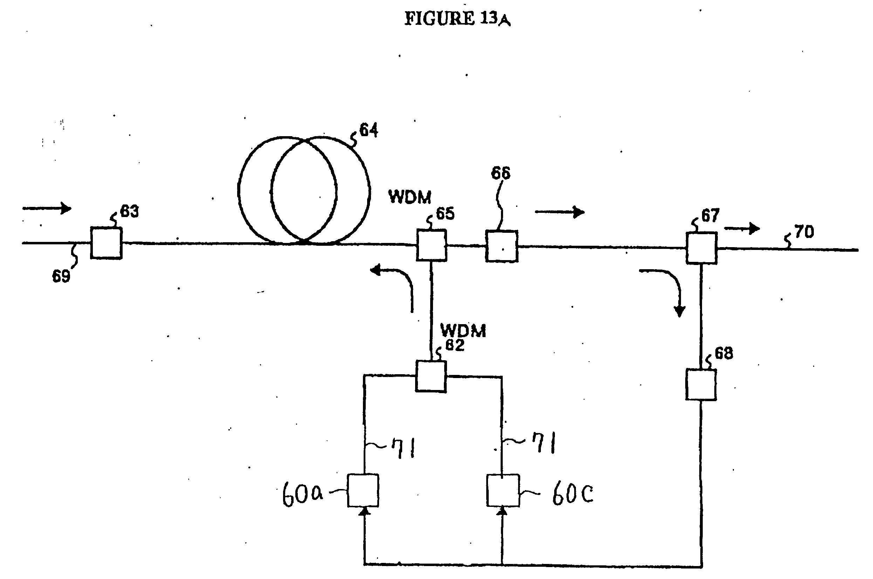

Moreover, the present inventors have recognized that the number of longitudinal modes included in the predetermined spectral width w should be at least three, as shown by modes 31, 32, and 33 of Figure 4. As discussed above, Raman amplification systems using a forward pumping method presents a problem in the resulting gain is dependent on the polarization of the incident pumping light. This dependency is canceled by performing polarization-multiplexing of pumping light beams output from two of the semiconductor laser devices 20, or by depolarizing a pumping light beam output from a single semiconductor laser device using polarization maintaining fibers as a depolarizer (these alternative embodiments are shown in Figures 13 and 13a respectively which will be further described below). In the latter case, the angle of the polarization axis of the polarization maintaining fiber against the emitted light from semiconductor laser device is approximately 45 degrees. With this configuration, an output of the laser device having a single polarization can obtain a random polarization by propagating a minimum distance through a polarization maintaining fiber. In general, the more the number of the oscillation longitudinal modes is increased, the shorter the length of the polarization maintaining fiber can be. Particularly, when the number of the oscillation longitudinal modes is more than three, preferably four or five, the coherence length of the laser light becomes shorter and the length of polarization maintaining fiber necessary for depolarizing the laser light becomes markedly short. Thus, it becomes easier to obtain a laser light of low degree of polarization (DOP) which is spectral for reducing the polarization dependency of a Raman amplifier, making it more feasible to replace 2 laser modules which are polarization-multiplexed with a single laser module with higher power and to thereby reduce the cost of lasers as well as polarization maintaining fibers.

In order to achieve the desired plurality of oscillation modes within the predetermined spectral width of the oscillation profile, the present inventors have recognized that the predetermined spectral width w and/or the wavelength interval $\Delta\lambda$ may be manipulated. However, a Raman amplification system poses limits on the values of the wavelength interval $\Delta\lambda$ and predetermined spectral width w of the oscillation wavelength spectrum 30. With regard to the wavelength interval $\Delta\lambda$, the present inventors have determined that this value should 0.1 nm or more as shown in Figure 4. This is because, in a case in which the semiconductor laser device 20 is used as a pumping light source of the Raman amplifier, if the wavelength interval $\Delta\lambda$ is 0.1 nm or more, it is unlikely that the stimulated Brillouin scattering is generated. With regard to the predetermined spectral width w of the oscillation wavelength profile 30, if the predetermined spectral width of the oscillation wavelength is too wide, the coupling loss by a wavelength-multiplexing coupler becomes larger. Moreover, a noise and a gain variation are generated due to the fluctuation of the wavelength within the spectrum width of the oscillation wavelength. Therefore, the present inventors have determined that the predetermined spectral width w of the oscillation wavelength spectrum 30 should be 3 nm or less as shown in Figure 4, and is preferably 2 nm or less.

In general, a wavelength interval $\Delta\lambda$ of the lon-

gitudinal modes generated by a resonator of a semiconductor device can be represented by the following equation:

$$\Delta\lambda = \lambda_0^2/(2 \cdot n \cdot L),$$

where n is the effective refractive index, $\lambda_0$ is the oscillation wavelength, and L is a length of the resonator defined by the reflection coating 14 and antireflection coating 15 as discussed with respect to Figures 1-3 above. From this equation it is seen that, neglecting refractive index n which has only a marginal affect on $\Delta\lambda$, the longer the resonator length is, the narrower the wavelength interval $\Delta\lambda$ becomes, and selection conditions for oscillating a laser beam of the signal longitudinal mode becomes stricter. However, in order to provide the desired plurality of longitudinal modes within a predetermined spectral width w of 3nm or less, the resonator length L cannot be made too short. For example, in the diffraction grating device of Figures 1-3 where the oscillation wavelength $\lambda_0$ is 1480 nm and the effective refractive index is 3.5, the wavelength interval $\Delta\lambda$ of the longitudinal mode is approximately 0.39 nm when the resonator length is 800 $\mu$m When the resonator length is 800 $\mu$m and or more, it is easy to obtain plurality of mode and higher output power. Likewise, the resonator length L must not be made so long that the required wavelength interval of 0.1 nm cannot be achieved. Returning to the example of Figures 1-3 when the resonator length is 3200 $\mu$m, the wavelength interval $\Delta\lambda$ of the longitudinal mode is approximately 0.1 nm.

Thus, for a semiconductor laser device having an oscillation wavelength $\lambda_0$ of 1480 nm and an effective refractive index of 3.5, the resonator cavity length L must approximately within the range of 800 to 3200 $\mu$m as indicated in Figure 2. It is noted that an integrated diffraction grating semiconductor laser device having such a resonator length L was not used in the conventional semiconductor laser devices because single longitudinal mode oscillation is difficult when the resonator length L is 800 $\mu$m or more. However, the semiconductor laser device 20 of the present invention, is intentionally made to provide a laser output with a plurality of oscillation longitudinal modes included within the predetermined spectral width w of the oscillation wavelength spectrum by actively making the resonator length L 800 $\mu$m or more. And Laser diode with such long resonator length is suitable to get high output power.

According to another embodiment, the objective of providing a plurality of operating modes within a predetermined spectral width w of the oscillation profile 30 is achieved by widening the predetermined spectral width w of the oscillation profile 30. In this embodiment, the predetermined spectral width w of the oscillation wavelength spectrum 30 is varied by changing a coupling coefficient K and/or a grating length Lg of the diffraction grating. Specifically, assuming a fixed multiplication coupling coefficient K*Lg (hereinafter "coupling coefficient") and a predetermined spectral width w defined by the FWHM points, where the grating length Lg of the resonator is decreased, the predetermined spectral width w is increased thereby allowing a greater number of longitudinal modes to occupy the predetermined spectral width w as laser operating modes. In this regard, it is noted that conventional integrated grating devices used only a full length grating structure. This is because these conventional devices provided only single mode operation in which it was undesirable to increase predetermined spectral width. The present inventors have discovered that shortening the grating is useful in providing multiple mode operation. In this way, the influence of the Fabry-Perot type resonator formed by the reflection coating 14 and the antireflection coating 15 can be smaller while widening the predetermined spectral width w in accordance with the present invention.

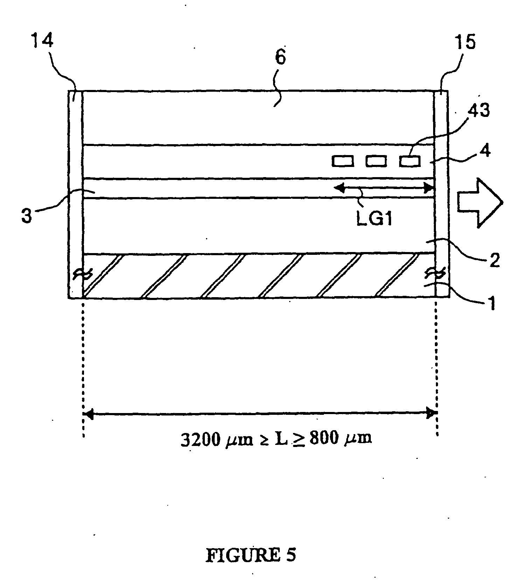

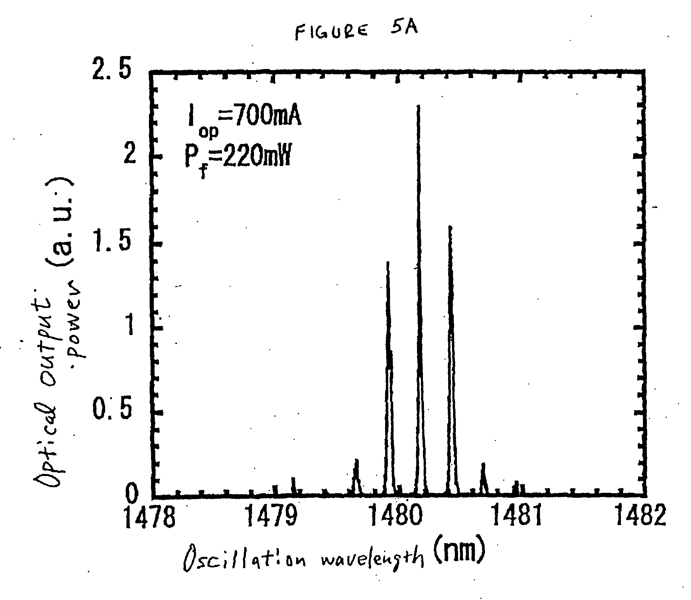

Figure 5 is a vertical sectional view in the longitudinal direction illustrating a general configuration of a semiconductor laser device according to an embodiment of the present invention. The semiconductor laser device shown in Figure 5 has an oscillation wavelength of 980-1550 nm, preferably 1480nm, and has a similar configuration as that of Figures 1-3 with the exception of the shortened diffraction grating 43 and the reflective properties of the reflection coating 14 and the antireflection coating 15. Diffraction grating 43 is a shortened grating positioned a predetermined length Lg1 from the antireflection coating 15. In this regard, the present inventors have discovered that if the diffraction grating 43 is formed substantially in the region of the antireflection coating 15, an ultra-low light reflecting coating should be applied as the antireflection coating 15 and a high light reflecting coating applied as the reflection coating 14. Thus, the reflection coating 14 and the antireflection coating 15 of Figure 5 preferably have a reflectivity of 80% or more, and 2% or less respectively. Moreover where the diffraction grating is formed in the antireflection coating 15 side as in Figure 5, it is preferable to set the reflectivity of the diffraction grating 43 itself rather low; therefore, the coupling coefficient K*Lg is preferably set to 0.3 or less, and more preferably set to 0.1 or less.

As a specific example of the of the diffraction grating semiconductor laser device illustrated in Figure 5, a resonator length L may be set to 1300$\mu$m and the grating length of the diffraction grating 43 to 100 $\mu$m with a coupling coefficient K*Lg of 0.1. With a front facet 15 reflectivity of 0.1% and a rear facet 14 reflectivity of 97%, a predetermined spectral width of the oscillation wavelength spectrum 30 is .5 to .6 nm and 3 oscillation modes can be included in the predetermined spectral width. Figure 5A is a graph showing the optical output power of such a semiconductor laser device as a function of oscillation wavelength. This laser device was also shown to have a RIN of under-140 db/Hz at about 10GHz and a driving current of over 300 mA.

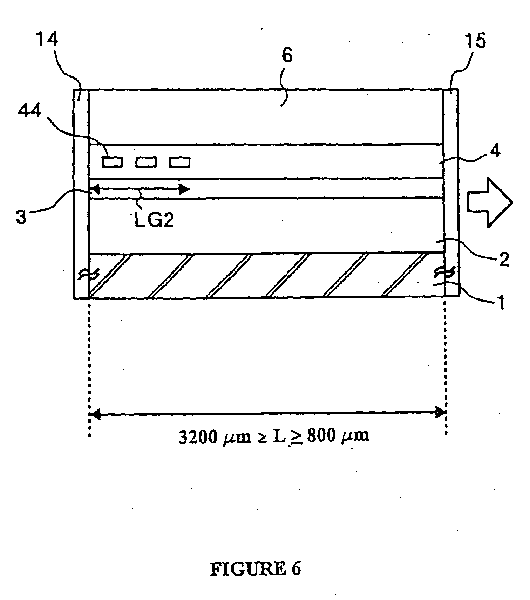

Figure 6 is a vertical sectional view in the longitudinal direction showing an integrated diffraction grating 44 provided in the reflection coating 14 side (i.e., rear facet) instead of the diffraction grating 43 illustrated in Figure 5. The present inventors have determined that if the diffraction grating 44 is formed substantially in the region of the reflection coating 14, an ultra-low light reflecting coating having the reflectivity of 1% to 5%, or more preferably 0.1 to 2% should be applied as the antireflection coating 15 as with the embodiment of Figure 5. However, unlike the laser device of Figure 5, the reflection coating 14 in Figure 6 has a low light reflectivity of 1 to 5% preferably .1% to 2%, and more preferably 0.1% or less. Moreover where the diffraction grating is formed in the reflection coating 15 side as in Figure 6, it is preferable to set the reflectivity of the diffraction grating 44 itself rather high; thus, the K*Lg is preferably set at 1 or more.

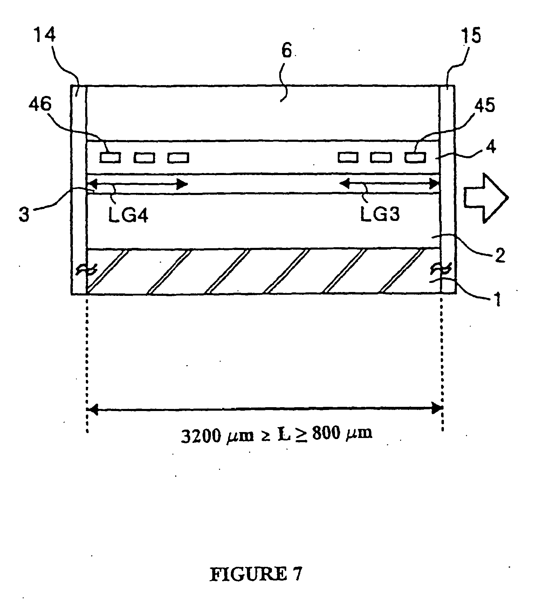

Figure 7 is a vertical sectional view in the longitudinal direction illustrating a configuration of a semiconductor laser device combining the structures of Figures 5 and 6. That is, the semiconductor laser device has a diffraction grating 45 formed a predetermined length Lg3 from the antireflective coating 15 which has an ultra-low light reflectivity of 0.1% to 2%, preferably 0.1% or less and a diffraction grating 46 formed a predetermined length Lg4 from the reflection coating 14 which also has the ultra-low light reflectivity of 0.1 to 2%, preferably 0.1% or less. Moreover, since the diffraction gratings 45 and 46 are formed in the antireflective coating 15 side and the reflection coating 14 side respectively, the reflectivity of the diffraction grating 45 itself is set rather low, and the reflectivity of the diffraction grating 46 itself is set rather high. More specifically, the K*Lg of the front facet is 0.3 or less and the K*Lg of the rear facet is 1 or more.

Thus, as illustrated in Figures 5-7, shortening of the diffraction grating of a semiconductor laser device widens the predetermined spectral width w of the oscillation wavelength spectrum thereby allowing the semiconductor laser device to provide the desired multiple longitudinal modes for Raman amplification even if the wavelength interval Δλ is fixed. Moreover, while Figures 5 through 7 show diffraction gratings 43 through 46 provided in the antireflective coating 15 side and/or the reflection coating 14 side, it is to be understood that the diffraction gratings are not limited to these configurations, and a diffraction grating having a partial length with respect to the resonator length L may be formed at any position along the GRIN-SCH-MQW active layer 3 as long as consideration is given to the reflectivity of the diffraction grating and reflecting and antireflective coatings.

In each of the embodiments previously described, the diffraction grating has a constant grating period. In yet another embodiment of the present invention, the predetermined spectral width w of the oscillation profile 30 is manipulated by varying the pitch of the diffraction grating. Specifically, the present inventors have realized that the wavelength oscillation profile 30 is shifted toward a longer wavelength where the width of the grating elements (i.e. the grating pitch) is increased. Similarly, the wavelength oscillation profile 30 is shifted toward a shorter wavelength where the grating pitch is decreased. Based on this realization, the present inventors have discovered that a chirped diffraction grating, wherein the grating period of the diffraction grating 13 is periodically changed, provides at least two oscillation profiles by the same laser device. These two oscillation profiles combine to provide a composite profile having a relatively wide predetermined spectral width w thereby effectively increasing the number of longitudinal modes within the predetermined spectral width w.

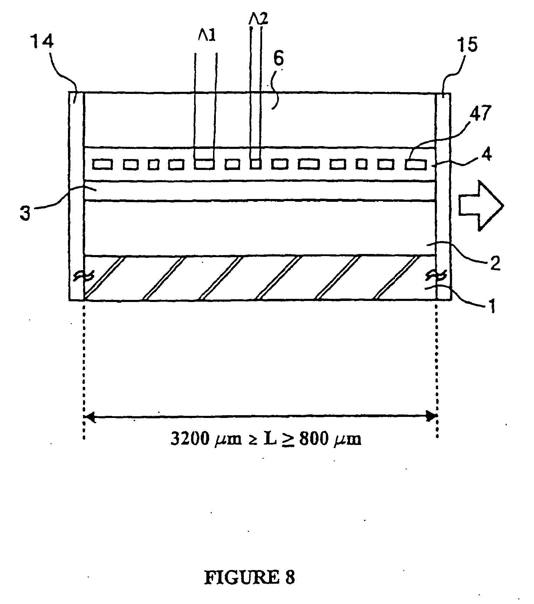

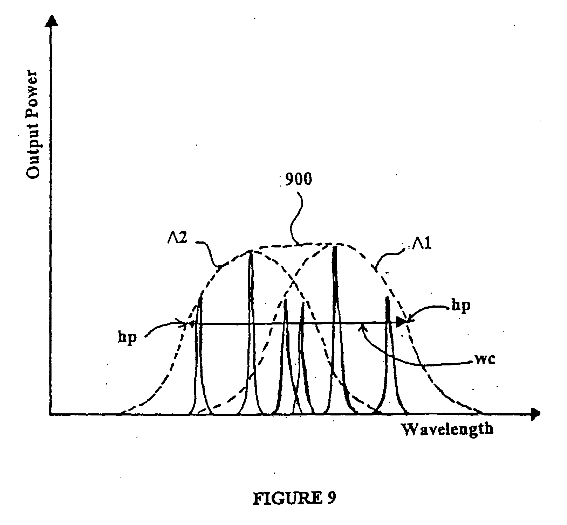

Figure 8 is a vertical sectional view in the longitudinal direction illustrating a general configuration of a semiconductor laser device having a chirped diffraction grating. As seen in this Figure, diffraction grating 47 is made to include at least two grating periods $\Lambda_1$ and $\Lambda_2$. Figure 9 is a graph illustrating the principle of a composite oscillation wavelength spectrum produced by the combined period $\Lambda_1$ and $\Lambda_2$ of Figure 8. As seen in Figure 9, an oscillation wavelength spectrum corresponding to $\Lambda_1$ is produced at a longer wavelength than the oscillation wavelength spectrum corresponding to $\Lambda_2$ since the pitch $\Lambda_1$ is larger than $\Lambda_2$. Where these individual oscillation wavelength spectrums are made to overlap such that a short wavelength half power point of the spectrum of $\Lambda_1$ is at a shorter wavelength than a long wavelength half power point of the spectrum of $\Lambda_2$, a composite oscillation wavelength spectrum 900 is formed as shown in Figure 9. This composite spectrum 900 defines a composite spectrum width of to thereby effectively widen the predetermined spectral width of wavelength oscillation spectrum to include a larger number of oscillation longitudinal modes.

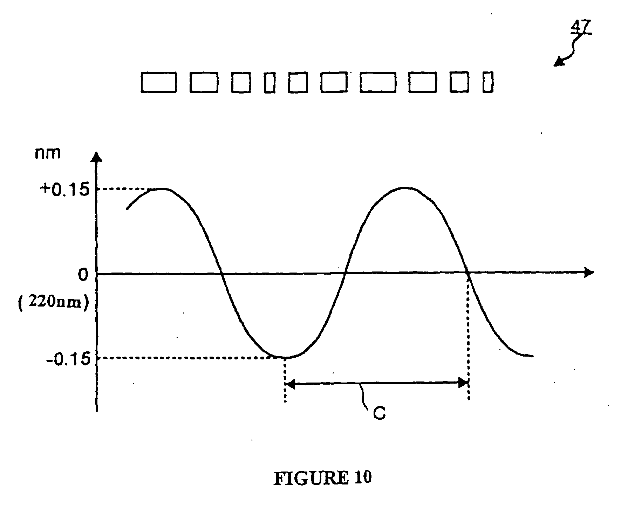

Figure 10 illustrates a periodic fluctuation of the grating period of the diffraction grating 47. As shown in Figure 10, the diffraction grating 47 has a structure in which the average period is 220 nm and the periodic fluctuation (deviation) of ±0.15 nm is repeated in the period C. In this example, the reflection band of the diffraction grating 47 has the half-width of approximately 2 nm by this periodic fluctuation of ±0.15 nm, thereby enabling three to six oscillation longitudinal modes to be included within the composite width wc of the composite oscillation wavelength spectrum.

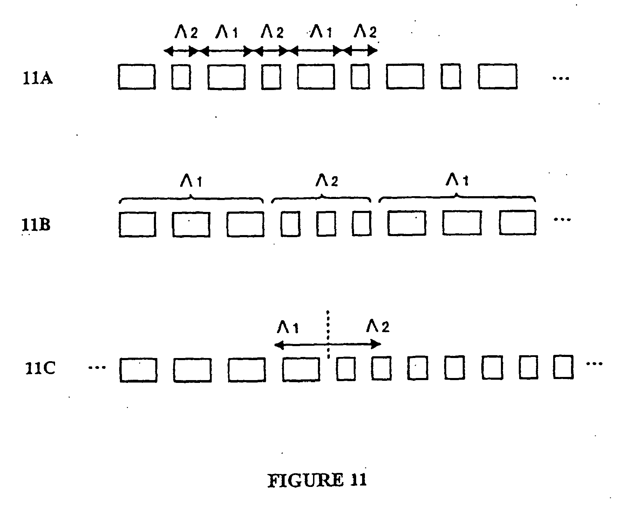

Although the chirped grating is the one in which the grating period is changed in the fixed period C in the above-mentioned embodiment, configuration of the present invention is not limited to this, and the grating period may be randomly changed between a period $\Lambda_1$ (220 nm + 0.15 nm) and a period $\Lambda_2$ (220 nm - 0.15 nm). Moreover, as shown in Figure 11A, the diffraction grating may be made to repeat the period $\Lambda_1$ and the period $\Lambda_2$ alternately and may be given fluctuation. In addition, as shown in Figure 11B, the diffraction grating may be made to alternatively repeat the period $\Lambda_1$ and the period $\Lambda_2$ for a plurality of times respectively and may be given fluctuation. As shown in Figure 11C, the diffraction grating may be made to have a plurality of successive periods $\Lambda_1$ and a plurality of successive periods $\Lambda_2$ and may be given fluctuation. Further, the diffraction grating may be disposed by supplementing a period having a discrete different value between the period $\Lambda_1$ and the period $\Lambda_2$

Thus, as illustrated by Figures 8-11, by giving the diffraction grating provided in the semiconductor laser device a periodic fluctuation of plus or minus a few nm with respect to an average period through the chirped grating, the predetermined spectral width of a composite oscillation wavelength spectrum wc can be set to a desired value. Therefore, an output laser beam with a plurality of oscillation longitudinal modes within the predetermined spectral width can be provided by a semiconductor laser device of this embodiment. Moreover, although the chirped grating of the above-described embodiments is set substantially equal to the resonator length L, it is to be understood that the configuration of the present invention is not limited to this and the chirped grating may be formed along a portion of the resonator L (i.e. the active layer) as previously described.

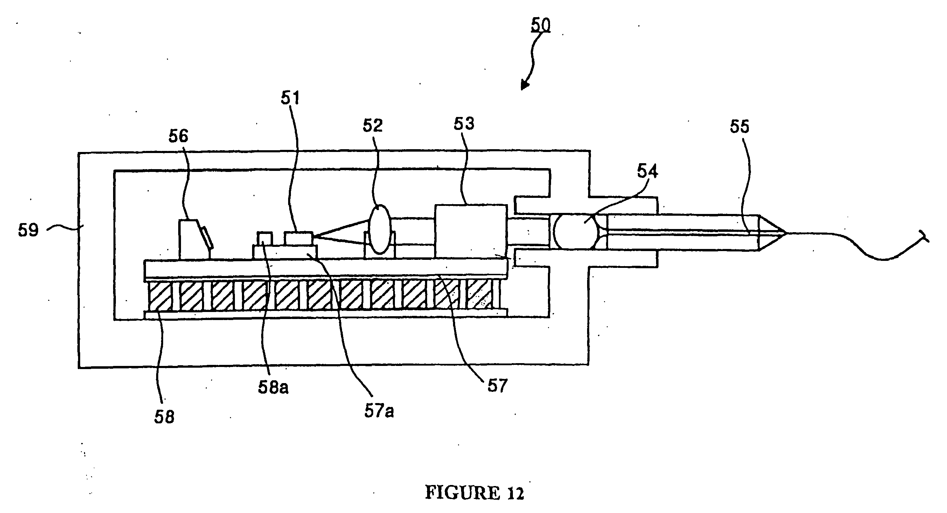

Figure 12 is a vertical sectional view illustrating the configuration of a semiconductor laser module having a semiconductor laser device. The semiconductor laser module 50 includes a semiconductor laser device 51, a first lens 52, an internal isolator 53, a second lens 54 and an optical fiber 55. Semiconductor laser device 51 is an integrated grating device configured in accordance with any of the above-described semiconductor laser devices and a laser beam irradiated from the semiconductor laser device 51 is guided to optical fiber 55 via first lens 52, internal isolator 53, and second lens 54. The second lens 54 is provided on the optical axis of the laser beam and is optically coupled with the optical fiber 55.

The present inventors have recognized that, in the semiconductor laser module 50 having the semiconductor laser device 51, since the diffraction grating is formed inside the semiconductor laser device 51, internal isolator 53 can be intervened between the semiconductor laser device 51 and the optical fiber 55. This provides an advantage in that reflected return light beams by other optical parts or from the external of the semiconductor laser nodule 50 are not re-inputted in the resonator of the laser device 51. Thus, the oscillation of the semiconductor laser device 51 can be stable even in the presence of reflection from outside. Moreover, placing the internal isolator 53 between the laser device 51 and optical fiber 55 does not introduce loss to the laser module. As is known in the art, the loss of an isolator is primarily in the area of a collecting lens which focuses the light beam onto a fiber at the output of the isolator material. The loss is caused by the coupling between this output lens and an output optical fiber. However, by using an internal isolator 53, the second lens 54 of the laser module 50 provides the function of the output lens of the isolator. Since the second lens 54 is necessary to the laser module 50 even without the internal isolator, the internal isolator 53 does not introduce any power loss into the laser module 50. In fact, use of the internal isolator reduces the loss of Raman amplifier system as will be further described below. Another advantage provided by the Internal isolator 53 is that it provides stable isolation characteristics. More specifically, since internal isolator 53 is in contact with the Peltier module 58, the internal isolator 53 is held at a constant temperature and therefore does not have the fluctuating isolation characteristics of an external isolator which is typically at ambient temperature.

A back face monitor photo diode 56 is disposed on a base 57 which functions as a heat sink and is attached to a temperature control device 58 mounted on the metal package 59 of the laser module 50. The back face monitor photo diode 56 detects a light leakage from the reflection coating side of the semiconductor laser device 51. The temperature control device 58 is a Peltier module. Although current (not shown) is given to the Peltier module 58 to perform cooling and heating by its polarity, the Peltier module 58 functions mainly as a cooler in order to prevent an oscillation wavelength shift by the increase of temperature of the semiconductor laser device 51. That is, if a laser beam has a longer wavelength compared with a desired wavelength, the Peltier element 58 cools the semiconductor laser device 51 and controls it at a low temperature, and if a laser beam has a shorter wavelength compared with a desired wavelength, the Peltier element 58 heats the semiconductor laser device 51 and controls it at a high temperature. By performing such a temperature control, the wavelength stability of the semiconductor laser device can improved. Alternatively, a thermistor 58a can be used to control the characteristics of the laser device. If the temperature of the laser device measured by a thermistor 58a located in the vicinity of the laser device 51 is higher, the Peltier module 58 cools the semiconductor laser device 51, and if the temperature is lower, the Peltier module 58 heats the semiconductor laser device 51. By performing such a temperature control, the wavelength and the output power intensity of the semiconductor laser device are stabilized.

Yet another advantage of the laser module 50 using the integrated laser device 15 that the Peltier module can be used to control the oscillation wavelength of the laser device. As described above, the wavelength selection characteristic of a diffraction grating is dependant on temperature, with the diffraction grating integrated in the semiconductor laser device the Peltier module 58 can be used to actively control the temperature of the grating and, therefore, the oscillation wavelength of the laser device.

Figure 13 is a block diagram illustrating a configuration of a Raman amplifier used in a WDM communication system. In Figure 13, semiconductor laser modules 60a through 60d are of the type described in the embodiment of Figure 12. The laser modules 60a and 60b output laser beams having the same wavelength via polarization maintaining fiber 71 to polarization-multiplexing coupler. Similarly, laser beams outputted by each of the semiconductor laser modules 60c and 60d have the same wavelength, and they are polarization-multiplexed by the polarization-multiplexing coupler 61b. Each of the laser modules 60a through 60d outputs a laser beam having a plurality of oscillation longitudinal modes to a respective polarization-multiplexing coupler 61 a and 61b via a polarization maintaining fiber 71.

Polarization-multiplexing couplers 61 a and 61 b output polarization-multiplexed laser beams having different wavelength to a WDM coupler 62. The WDM coupler 62 multiplexes the laser beams outputted from the polarization multiplexing couplers 61a and 61b, and outputs the multiplexed light beams as a pumping light beam to amplifying fiber 64 via WDM coupler 65. Thus, as seen in Figure 13, a Raman amplifier using a laser module does not include an external isolator such as isolator 60 of Figure 17. Therefore, the loss associated with the external isolator, as discussed above, is eliminated from the Raman amplifier system of Figure 13. Signal light beams to be amplified are input to amplifying fiber 64 from signal light inputting fiber 69 via polarization-independent isolator 63. The amplified signal light beams are Raman-amplified by being multiplexed with the pumping light beams and input to a monitor light branching coupler 67 via the WDM coupler 65 and the polarization-independent isolator 66. The monitor light branching coupler 67 outputs a portion of the amplified signal light beams to a control circuit 68, and the remaining amplified signal light beams as an output laser beam to signal light outputting fiber 70.

The control circuit 68 controls a light-emitting state, for example, an optical intensity, of each of the semiconductor light-emitting elements 180a through 180d based on the portion of the amplified signal light beams input to the control circuit 68. Moreover, control circuit 68 performs feedback control of a gain band of the Raman amplification such that the gain band will be flat over wavelength.

The Raman amplifier described in Figure 13 realizes all of the advantages of the semiconductor laser device as previously described. For example, although the Raman amplifier illustrated in Figure 13 is the backward pumping method, since the semiconductor laser modules 60a through 60d output stable pumping light beams, a stable Raman amplification can be performed whether the Raman amplifier is the forward pumping method or the bi-directional pumping method.

The Raman amplifier can be constructed by wavelength-multiplexing of a plurality of pumping light which are not polarization-multiplexed. That is, the semiconductor laser module can be used in a Raman amplifier where the polarization-multiplexing of pumping light is not performed. Figure 13A is a block diagram illustrating a configuration of a Raman amplifier in which polarization dependency is canceled by depolarizing a pumping light beam output from a single semiconductor laser device using polarization maintaining fibers as a depolarizer. As seen in this figure, laser modules 60A and 60C are directly connected to WDM coupler 62 via a polarization maintaining fiber 71. In this configuration, the angle of the polarization axis of the polarization maintaining fiber against the emitted light from semiconductor laser device is approximately 45 degrees. As mentioned above, since at least 3 longitudinal modes are included in the predetermined spectral width of the output spectrum of the laser light, the coherence length of the laser light becomes shorter and the length of polarization maintaining fiber necessary for depolarizing the laser light becomes markedly short. Thus, it becomes easier to obtain a laser light of low degree of polarization (DOP) which is spectral for reducing the polarization dependency of a Raman amplifier. Therefore, the laser device provides a further advantage in that it is possible to substitute 2 units of laser modules which are polarization-multiplexed (as shown in Figure 13) for one unit of depolarized laser module of greater power (as shown in Figure 13A), without deteriorating DOP and while obtaining a corresponding reduction in costs.

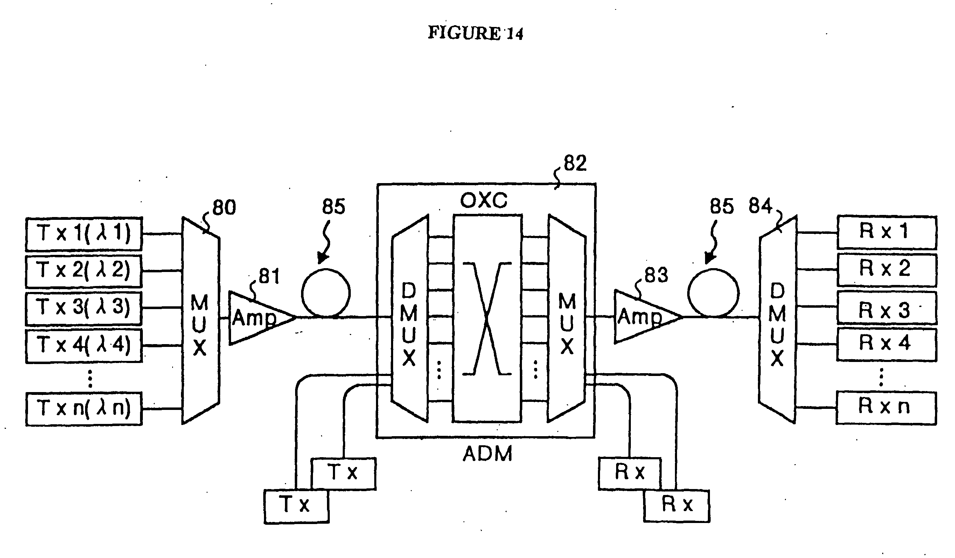

The Raman amplifier illustrated in Figures 13 and 13A can be applied to the WDM communication system as described above. Figure 14 is a block diagram illustrating a general configuration of the WDM communication system to which the Raman amplifier shown in either Figure 13 or Figure 13A is applied.

In Figure 14, optical signals of wavelengths $\lambda_1$ through $\lambda_n$ are forwarded from a plurality of transmitter $Tx_1$ through $Tx_n$ to multiplexing coupler 80 where they are wavelength-multiplexed and output to optical fiber 85 line for transmission to a remote communications unit. On a transmission route of the optical fiber 85, a plurality of Raman amplifiers 81 and 83 corresponding to the Raman amplifier illustrated in Figure 13 are disposed amplifying an attenuated optical signal. A signal transmitted on the optical fiber 85 is divided by an optical demultiplexer 84 into optical signals of a plurality of wavelengths $\lambda_1$ through $\lambda_n$, which are received by a plurality of receivers $Rx_1$ through $Rx_n$. Further, an ADM (Add/Drop Multiplexer) may be inserted on the optical fiber 85 for inserting and removing an optical signal of an arbitrary wavelength.

Obviously, numerous modifications and variations of the present invention are possible in light of the above teachings. It is therefore to be understood that within the scope of the appended claims, the invention may be practiced otherwise than as specifically described herein. For example, the present invention has been described as a pumping light source for the Raman amplification, it is evident that the configuration is not limited to this usage and may be used as an EDFA pumping light source of the oscillation wavelength of 980nm and 1480nm.

## Claims

1. A semiconductor device comprising:

    an active layer (3) configured to radiate light;
    a diffraction grating (13),
    a reflection coating (14) positioned at a first end of said active layer (3) and substantially perpendicular thereto; and
    an antireflective coating (15) positioned at a second end of said active layer (3) opposing said first end and substantially perpendicular to said active layer (3),

    wherein said reflection coating (14) and said antireflective coating (13) define a resonant cavity within said active layer and
    wherein said diffraction grating (13) is configured to select a plurality of longitudinal modes within a predetermined spectral width of an oscillation wavelength spectrum of the semiconductor device **characterized in that** a length (L) of said resonant cavity is at least 800 μm for reducing stimulated Brillouin scattering while pumping a Raman amplifier.

2. The semiconductor device of claim 1, wherein a length (L) of said resonant cavity is not greater than 3200μm.

3. The semiconductor device of claim 1, wherein said diffraction grating (13) is formed substantially along an entire length of said active layer (3).

4. The semiconductor device of claim 3, wherein said diffraction grating (13) comprises a plurality of grating elements having a constant pitch.

5. The semiconductor device of claim 3, wherein said diffraction grating (13) comprises a chirped grating (47) having a plurality of grating elements having fluctuating pitches.

6. The semiconductor device of claim 5, wherein said chirped grating is formed such that a fluctuation in the pitch of said plurality of grating elements is a random fluctuation.

7. The semiconductor device of claim 5, wherein said chirped grating (47) is formed such that a fluctuation in the pitch of said plurality of grating elements is a periodic fluctuation.

8. The semiconductor device of claim 1, wherein said diffraction grating is a shortened diffraction grating (43, 44, 45, 46) formed along a portion of an entire length of said active layer.

9. The semiconductor device of claim 8, wherein said diffraction grating (43, 44, 45, 46) comprises a plurality of grating elements having a constant pitch.

10. The semiconductor device of claim 8, wherein said diffraction grating comprises a chirped grating (47) having a plurality of grating elements having fluctuation pitches.

11. The semiconductor device of claim 10, wherein said chirped grating (47) is formed such that a fluctuation in the pitch of said plurality of grating elements is a random fluctuation.

12. The semiconductor device of claim 10, wherein said chirped grating (47) is formed such that a fluctuation in the pitch of said plurality of grating elements is a periodic fluctuation.

13. The semiconductor device of claim 8, wherein said diffraction grating is configured to set the predetermined spectral width to no more than 3 nm.

14. The semiconductor device of claim 8, wherein said shortened diffraction grating (43, 45) is positioned along a portion of the active layer (3) adjacent to said antireflective coating.

15. The semiconductor device of claim 14, wherein said antireflective coating (15) has an ultra-low reflectivity of approximately 0.1% to 2%.

16. The semiconductor device of claim 14, wherein said antireflective coating (15) has an ultra-low reflectivity of approximately 0.1% or less.

17. The semiconductor device of claim 14 wherein said reflection coating (14) has a high reflectivity of at least 80%.

18. The semiconductor device of claim 14, wherein said shortened diffraction grating (43, 45) has a coupling coefficient K*Lg of approximately .3 or less.

19. The semiconductor device of claim 14, wherein said shortened diffraction grating (43, 45) has a coupling coefficient K*Lg of approximately .1 or less.

20. The semiconductor device of claim 8, wherein said shortened diffraction grating (44, 46) is positioned along a portion of the active layer adjacent to said reflection coating (14).

21. The semiconductor device of claim 20, wherein said antireflective coating has a low reflectivity of approximately 1% to 5%.

22. The semiconductor device of claim 20, wherein said reflection coating (14) has an ultra-low reflectivity of approximately 0.1% to 2%.

23. The semiconductor device of claim 20, wherein said reflection coating (14) has an ultra-low reflectivity of approximately 0.1% or less.

24. The semiconductor device of claim 20, wherein said shortened diffraction grating (44, 46) has a coupling coefficient K*Lg of approximately 1 or more.

25. The semiconductor device of claim 20, wherein said shortened diffraction grating (44, 46) has a coupling coefficient K*Lg of approximately 3 or more.

26. The semiconductor device of claim 8, wherein said shortened diffraction grating comprises a first shortened diffraction grating (45) positioned along a portion of the active layer (3) adjacent to said antireflective coating (15), and a second shortened diffraction grating (46) positioned along a portion of the active layer adjacent to said reflection coating (14).

27. The semiconductor device of claim 26, wherein said antireflective coating (15) and said reflection coating (14) have an ultra-low reflectivity of approximately 0.1% to 2%.

28. The semiconductor device of claim 26, wherein said antireflective coating (15) and said reflection coating (14) have an ultra-low reflectivity of approximately 0.1 % or less.

29. The semiconductor device of claim 26, wherein said first shortened diffraction grating (45) comprises a first shortened diffraction grating (45) having a coupling coefficient K*Lg of approximately .3 or less.

30. The semiconductor device of claim 26, wherein said second shortened diffraction grating (46) comprises a second shortened diffraction grating (46) having a coupling coefficient K*Lg of approximately 1 or more.

31. A method for providing light from a semiconductor laser device (20), comprising:

   radiating light from an active layer (3) of said semiconductor laser device (20);
   providing a diffraction grating (13) within said semiconductor laser device to select a portion of said radiated light to be emitted by said semiconductor laser device (20) as an output light beam; and
   selecting physical parameters of said semiconductor laser device (20) such that said output light beam has an oscillation wavelength spectrum having a plurality of longitudinal modes located within a predetermined spectral width (w)

of the oscillation wavelength spectrum,

wherein said step of selecting physical parameters comprises setting a length (L) of a resonant cavity of said semiconductor laser device (20) to provide a predetermined wavelength interval ($\Delta\lambda$) between said plurality of longitudinal modes and setting the length (L) such that said plurality of longitudinal modes is provided within said predetermined spectral width (w) of the oscillation wavelength spectrum, **characterized in that** said step of setting the length (L) of a resonant cavity comprises setting the cavity length (L) to at least 800 $\mu$m for reducing stimulated Brillouin scattering while pumping a Raman amplifier.

32. The method of claim 31, wherein said step of setting the length (L) of a resonant cavity comprises setting the length (L) such that the wavelength interval ($\Delta\lambda$) between said plurality of longitudinal modes is at least 0.1 nm.

33. The method of claim 32, wherein said step of setting the length (L) of said resonant cavity comprises setting the cavity length (L) to no more than 3,200 $\mu$m.

34. The method of claim 31, wherein said step of selecting physical parameters comprises setting a length (LG) of said diffraction grating (43, 44, 45, 46) to be shorter than a length of said active layer to thereby widen said predetermined spectral width (w) of the oscillation wavelength spectrum.

35. The method of claim 34, further comprising positioning said diffraction grating (43, 45) adjacent to an antireflective coating (15) of the semiconductor laser device.

36. The method of claim 35, further comprising setting a reflectivity of said antireflective coating (15) to approximately 0.1% to 2%.

37. The method of claim 35, further comprising setting a reflectivity of said antireflective coating (15) to approximately 0.1% or less.

38. The method of claim 35, further comprising setting a reflectivity of a reflection coating (14) opposed to said antireflective coating (15) to at least 80%.

39. The method of claim 35, further comprising setting a coupling coefficient K*Lg of approximately .3 or less

40. The method of claim 35, further comprising setting a coupling coefficient K*Lg of approximately .1 or less.

**41.** The method of claim 34, further comprising positioning said diffraction grating (44, 46) in the vicinity of adjacent to a reflection coating (14) of the semiconductor laser device.

**42.** The method of claim 41, further comprising setting a reflectivity of said reflection coating (14) to approximately 0.1 % to 2%.

**43.** The method of claim 41, further comprising setting a reflectivity of said reflection coating (14) to approximately 0.1% or less.

**44.** The method of claim 41, further comprising setting a reflectivity of an antireflective coating (15) opposed to said reflection coating (14) to approximately 1% to 5%.

**45.** The method of claim 41, further comprising setting a coupling coefficient K*Lg of approximately 1 or more.

**46.** The method of claim 41, further comprising setting a coupling coefficient K*Lg of approximately 3 or more.

**47.** The method of claim 34, further comprising positioning said diffraction grating as a first shortened diffraction grating (45) adjacent to an antireflective coating (15) of the semiconductor laser device and a second shortened diffraction grating (46) adjacent to a reflection coating (14) opposed to said antireflective coating (15).

**48.** The method of claim 47, further comprising setting a reflectivity of said antireflective coating and said reflection coating to approximately 0.1% to 2%.

**49.** The method of claim 47, further comprising setting a reflectivity of said antireflective coating and said reflection coating to approximately 0.1% or less.

**50.** The method of claim 47, further comprising setting a coupling coefficient K*Lg of said first and second diffraction gratings (45, 46) is approximately .3 or less, and approximately 1 or more respectively.

**51.** The method of claim 31, wherein said step of selecting physical parameters comprises forming said diffraction grating (13) as a chirped grating having a plurality of grating elements having fluctuating pitches to thereby widen said predetermined spectral width (w) of the oscillation wavelength spectrum.

**52.** The method of claim 51, wherein said step of forming said chirped grating comprises forming the chirped grating such that a fluctuation in the pitch of said plurality of grating elements is a random fluctuation.

**53.** The method of claim 51, wherein said step of forming said chirped grating comprises forming the chirped grating such that a fluctuation in the pitch of said plurality of grating elements is a periodic fluctuation.

**54.** A semiconductor laser module comprising:

the semiconductor laser device (51) according to one of claims 1 to 30.

**55.** The semiconductor laser module of claim 54, further comprising an internal isolator (53) interposed between said semiconductor laser device (51) and an optical fiber (55) coupled to an output of said semiconductor laser module.

**56.** The semiconductor laser module of claim 55, further comprising a temperature control device (58) configured to control a isolation characteristics of said internal isolator (53).

**57.** The semiconductor laser module 54, further comprising a temperature control device (58) configured to control an oscillation wavelength of said semiconductor laser device (51).

**58.** The semiconductor laser module of claim 57, wherein said temperature control device (58) comprises a Peltier module (58a).

**59.** The semiconductor laser module of claim 57, wherein said temperature control device (58) comprises a thermister (58a).

**60.** The semiconductor laser module of claim 54, further comprising a polarization maintaining fiber (71), wherein an angle of the polarization axis of the polarization maintaining fiber (71) to emitted light from the semiconductor laser device is approximately 45 degrees.

**61.** An optical fiber amplifier comprising:

the semiconductor laser device (51) according to one of claims 1 to 30.

**62.** A wavelength division multiplexing system comprising:

the optical fiber amplifier according to claim 61.

**63.** A Raman amplifier comprising:

a semiconductor laser device according to one of claims 1 to 30.

**64.** The Raman amplifier of claim 63, wherein said semiconductor laser device is directly connected to a wavelength division multiplexing coupler (62) via a polarization maintaining fiber (71).

**65.** The Raman amplifier of claim 69 wherein an angle of polarization axis of the polarization maintaining fiber (71) to emitted light from said semiconductor laser device is approximately 45 degrees.

**Patentansprüche**

**1.** Halbleitervorrichtung, die umfasst:

eine aktive Schicht (3), die so konfiguriert ist, dass sie Licht abstrahlt;
ein Beugungsgitter (13),
eine Reflexionsbeschichtung (14), die an einem ersten Ende der aktiven Schicht (3) und im Wesentlichen senkrecht hierzu positioniert ist; und
eine antireflektierende Schicht (15), die an einem zweiten Ende der aktiven Schicht (3) gegenüber dem ersten Ende und im Wesentlichen senkrecht zu der aktiven Schicht (3) positioniert ist,

wobei die Reflexionsbeschichtung (14) und die antireflektierende Beschichtung (13) in der aktiven Schicht einen Resonanzhohlraum definieren und wobei das Beugungsgitter (13) so konfiguriert ist, dass es mehrere longitudinale Moden in einer vorgegebenen Spektralbreite eines Oszillationswellenlängenspektrums der Halbleitervorrichtung auswählt,
**dadurch gekennzeichnet, dass** eine Länge (L) des Resonanzhohlraums wenigstens 800 $\mu$m beträgt, um während des Pumpens eines Raman-Verstärkers eine stimulierte Brillouin-Streuung zu reduzieren.

**2.** Halbleitervorrichtung nach Anspruch 1, bei der eine Länge (L) des Resonanzhohlraums nicht größer als 3200 $\mu$m ist.

**3.** Halbleitervorrichtung nach Anspruch 1, bei der das Beugungsgitter (13) im Wesentlichen über die gesamte Länge der aktiven Schicht (3) ausgebildet ist.

**4.** Halbleitervorrichtung nach Anspruch 3, bei der das Beugungsgitter (13) mehrere Gitterelemente mit konstanter Schrittweite umfasst.

**5.** Halbleitervorrichtung nach Anspruch 3, bei der das Beugungsgitter (13) ein gechirptes Gitter (47) mit mehreren Gitterelementen mit unterschiedlichen Schrittweiten umfasst.

**6.** Halbleitervorrichtung nach Anspruch 5, bei der das gechirpte Gitter in der Weise ausgebildet ist, dass eine Fluktuation der Schrittweite der mehreren Gitterelemente eine Zufallsfluktuation ist.

**7.** Halbleitervorrichtung nach Anspruch 5, bei der das gechirpte Gitter (47) in der Weise ausgebildet ist, dass eine Fluktuation der Schrittweite der mehreren Beugungsgitter eine periodische Fluktuation ist.

**8.** Halbleitervorrichtung nach Anspruch 1, bei der das Beugungsgitter ein verkürztes Beugungsgitter (43, 44, 45, 46) ist, das längs eines Abschnitts der Gesamtlänge der aktiven Schicht ausgebildet ist.

**9.** Halbleitervorrichtung nach Anspruch 8, bei der das Beugungsgitter (43, 44, 45, 46) mehrere Gitterelemente mit konstanter Schrittweite umfasst.

**10.** Halbleitervorrichtung nach Anspruch 8, bei der das Beugungsgitter ein gechirptes Gitter (47) mit mehreren Gitterelementen mit fluktuierenden Schrittweiten umfasst.

**11.** Halbleitervorrichtung nach Anspruch 10, bei der das gechirpte Gitter (47) in der Weise ausgebildet ist, dass eine Fluktuation der Schrittweite der mehreren Gitterelemente eine Zufallsfluktuation ist.

**12.** Halbleitervorrichtung nach Anspruch 10, bei der das gechirpte Gitter (47) in der Weise ausgebildet ist, dass eine Fluktuation der Schrittweite der mehreren Gitterelemente eine periodische Fluktuation ist.

**13.** Halbleitervorrichtung nach Anspruch 8, bei der das Beugungsgitter so konfiguriert ist, dass die vorgegebene Spektralbreite auf nicht mehr als 3 nm gesetzt ist.

**14.** Halbleitervorrichtung nach Anspruch 8, bei der das verkürzte Beugungsgitter (43, 45) längs eines Abschnitts der aktiven Schicht (3) angrenzend an die antireflektierende Beschichtung positioniert ist.

**15.** Halbleitervorrichtung nach Anspruch 14, bei der die antireflektierende Beschichtung (15) ein ultraniedriges Reflexionsvermögen von etwa 0,1 % bis 2 % besitzt.

**16.** Halbleitervorrichtung nach Anspruch 14, bei der die antireflektierende Beschichtung (15) ein ultraniedriges Reflexionsvermögen von etwa 0,1 % oder weniger besitzt.

**17.** Halbleitervorrichtung nach Anspruch 14, bei der die Reflexionsbeschichtung (14) ein hohes Reflexionsvermögen von wenigstens 80 % hat.

**18.** Halbleitervorrichtung nach Anspruch 14, bei der das verkürzte Beugungsgitter (43, 45) einen Kopplungskoeffizienten K*Lg von etwa 0,3 oder weniger hat.

**19.** Halbleitervorrichtung nach Anspruch 14, bei der das verkürzte Beugungsgitter (43, 45) einen Kopplungskoeffizienten K*Lg von etwa 0,1 oder weniger hat.

**20.** Halbleitervorrichtung nach Anspruch 8, bei der das verkürzte Beugungsgitter (44, 46) längs eines Abschnitts der aktiven Schicht angrenzend an die Reflexionsbeschichtung (14) positioniert ist.

**21.** Halbleitervorrichtung nach Anspruch 20, bei der die antireflektierende Beschichtung ein niedriges Reflexionsvermögen von etwa 1 % bis 5 % besitzt.

**22.** Halbleitervorrichtung nach Anspruch 20, bei der die Reflexionsbeschichtung (14) ein ultraniedriges Reflexionsvermögen von etwa 0,1% bis 2 % besitzt.

**23.** Halbleitervorrichtung nach Anspruch 20, bei der die Reflexionsbeschichtung (14) ein ultraniedriges Reflexionsvermögen von etwa 0,1% oder weniger besitzt.

**24.** Halbleitervorrichtung nach Anspruch 20, bei der das verkürzte Beugungsgitter (44, 46) einen Kopplungskoeffizienten K*Lg von etwa 1 oder mehr besitzt.

**25.** Halbleitervorrichtung nach Anspruch 20, bei der das verkürzte Beugungsgitter (44, 46) einen Kopplungskoeffizienten K*Lg von etwa 3 oder mehr besitzt.

**26.** Halbleitervorrichtung nach Anspruch 8, bei der das verkürzte Beugungsgitter ein erstes verkürztes Beugungsgitter (45), das längs eines Abschnitts der aktiven Schicht (3) angrenzend an die antireflektierende Beschichtung (15) positioniert ist, und ein zweites verkürztes Beugungsgitter (46), das längs eines Abschnitts der aktiven Schicht angrenzend an die Reflexionsbeschichtung (14) positioniert ist, umfasst.

**27.** Halbleitervorrichtung nach Anspruch 26, bei der die antireflektierende Beschichtung (15) und die Reflexionsbeschichtung (14) ein ultraniedriges Reflexionsvermögen von etwa 0,1 % bis 2 % besitzen.

**28.** Halbleitervorrichtung nach Anspruch 26, bei der die antireflektierende Beschichtung (15) und die Reflexionsbeschichtung (14) ein ultraniedriges Reflexionsvermögen von etwa 0,1 % oder weniger besitzen.

**29.** Halbleitervorrichtung nach Anspruch 26, bei der das erste verkürzte Beugungsgitter (45) ein erstes verkürztes Beugungsgitter (45) mit einem Kopplungskoeffizienten K*Lg von etwa 0,3 oder weniger umfasst.

**30.** Halbleitervorrichtung nach Anspruch 26, bei der das zweite verkürzte Beugungsgitter (46) ein zweites verkürztes Beugungsgitter (46) mit einem Kopplungskoeffizienten K*Lg von etwa 1 oder mehr umfasst.

**31.** Verfahren für die Bereitstellung von Licht von einer Halbleiterlaservorrichtung (20), das umfasst:

Abstrahlen von Licht von einer aktiven Schicht (3) der Halbleiterlaservorrichtung (20);
Vorsehen eines Beugungsgitters (13) in der Halbleiterlaservorrichtung, um einen Teil des abgestrahlten Lichts, das von der Halbleiterlaservorrichtung (20) emittiert werden soll, als einen Ausgangslichtstrahl auszuwählen; und
Auswählen physikalischer Parameter der Halbleiterlaservorrichtung (20) in der Weise, dass der Ausgangslichtstrahl ein Oszillationswellenlängenspektrum mit mehreren longitudinalen Moden, die innerhalb einer vorgegebenen Spektralbreite (w) des Oszillationswellenlängenspektrums liegen, besitzt,

wobei der Schritt des Auswählens physikalischer Parameter das Einstellen einer Länge (L) eines Resonanzhohlraums der Halbleiterlaservorrichtung (20), um ein vorgegebenes Wellenlängenintervall ($\Delta\lambda$) zwischen den mehreren longitudinalen Moden zu schaffen, und das Einstellen der Länge (L) in der Weise, dass die mehreren longitudinalen Moden innerhalb der vorgegebenen Spektralbreite (w) des Oszillationswellenlängenspektrums liegen, umfasst,
**dadurch gekennzeichnet, dass** der Schritt des Einstellens der Länge (L) des Resonanzhohlraums das Einstellen der Wellenlängen (L) auf wenigstens 800 $\mu$m umfasst, um während des Pumpens eines Raman-Verstärkers eine stimulierte Brillouin-Streuung zu verringern.

**32.** Verfahren nach Anspruch 31, bei dem der Schritt des Einstellens der Länge (L) eines Resonanzhohlraums das Einstellen der Länge (L) in der Weise, dass das Wellenlängenintervall ($\Delta\lambda$) zwischen den mehreren longitudinalen Moden wenigstens 0,1 nm beträgt, umfasst.

**33.** Verfahren nach Anspruch 32, bei dem der Schritt des Einstellens der Länge (L) des Resonanzhohlraums das Einstellen der Hohlraumlänge (L) auf nicht mehr als 3200 $\mu$m umfasst.

**34.** Verfahren nach Anspruch 31, bei dem der Schritt des Auswählens physikalischer Parameter das Einstellen einer Länge (LG) des Beugungsgitters (43, 44, 45, 46) in der Weise, dass sie kürzer als eine Länge der aktiven Schicht ist, umfasst, wodurch die vorgegebene Spektralbreite (w) des Oszillationswellenlängenspektrums erweitert wird.

35. Verfahren nach Anspruch 34, das ferner das Positionieren des Beugungsgitters (43, 45) in der Nähe einer antireflektierenden Beschichtung (15) der Halbleiterlaservorrichtung umfasst.

36. Verfahren nach Anspruch 35, das ferner das Setzen eines Reflexionsvermögens der antireflektierenden Beschichtung (15) auf etwa 0,1 % bis 2 % umfasst.

37. Verfahren nach Anspruch 35, das ferner das Setzen eines Reflexionsvermögens der antireflektierenden Beschichtung (15) auf etwa 0,1 % oder weniger umfasst.

38. Verfahren nach Anspruch 35, das ferner das Setzen eines Reflexionsvermögens einer Reflexionsbeschichtung (14) gegenüber der antireflektierenden Beschichtung (15) auf wenigstens 80 % umfasst.

39. Verfahren nach Anspruch 35, das ferner das Setzen eines Kopplungskoeffizienten K*Lg auf etwa 0,3 oder weniger umfasst.

40. Verfahren nach Anspruch 35, das ferner das Setzen eines Kopplungskoeffizienten K*Lg auf etwa 0,1 oder weniger umfasst.

41. Verfahren nach Anspruch 34, das ferner das Positionieren des Beugungsgitters (44, 46) angrenzend an eine Reflexionsbeschichtung (14) der Halbleiterlaservorrichtung umfasst.

42. Verfahren nach Anspruch 41, das ferner das Setzen eines Reflexionsvermögens der Reflexionsbeschichtung (14) auf etwa 0,1 % bis 2 % umfasst.

43. Verfahren nach Anspruch 41, das ferner das Setzen eines Reflexionsvermögens der Reflexionsbeschichtung (14) auf etwa 0,1% oder weniger umfasst.

44. Verfahren nach Anspruch 41, das ferner das Setzen eines Reflexionsvermögens einer antireflektierenden Beschichtung (15) gegenüber der Reflexionsbeschichtung (14) auf etwa 1 % bis 5 % umfasst.

45. Verfahren nach Anspruch 41, das ferner das Setzen eines Kopplungskoeffizienten K*Lg auf etwa 1 oder mehr umfasst.

46. Verfahren nach Anspruch 41, das ferner das Setzen eines Kopplungskoeffizienten K*Lg auf etwa 3 oder mehr umfasst.

47. Verfahren nach Anspruch 34, das ferner das Positionieren des Beugungsgitters als ein erstes verkürztes Beugungsgitter (45) angrenzend an eine antireflektierende Beschichtung (15) der Halbleiterlaservorrichtung und als ein zweites verkürztes Beugungsgitter (46) angrenzend an eine Reflexionsbeschichtung (14) gegenüber der antireflektierenden Beschichtung (15) umfasst.

48. Verfahren nach Anspruch 47, das ferner das Setzen eines Reflexionsvermögens der antireflektierenden Beschichtung und der Reflexionsbeschichtung auf etwa 0,1 % bis 2 % umfasst.

49. Verfahren nach Anspruch 47, das ferner das Setzen eines Reflexionsvermögens der antireflektierenden Beschichtung und der Reflexionsbeschichtung auf etwa 0,1 % oder weniger umfasst.

50. Verfahren nach Anspruch 47, das ferner das Setzen eines Kopplungskoeffizienten K*Lg des ersten und des zweiten Beugungsgitters (45, 46) auf etwa 0,3 oder weniger bzw. auf etwa 1 oder mehr umfasst.

51. Verfahren nach Anspruch 31, bei dem der Schritt des Auswählens physikalischer Parameter das Bilden des Beugungsgitters (13) als ein gechirptes Gitter mit mehreren Gitterelementen mit unterschiedlichen Schrittweiten umfasst, wodurch die vorgegebene Spektralbreite (w) des Oszillationswellenlängenspektrums erweitert wird.

52. Verfahren nach Anspruch 51, bei dem der Schritt des Bildens des gechirpten Gitters das Bilden des gechirpten Gitters in der Weise, dass die Fluktuation der Schrittweite der mehreren Gitterelemente eine Zufallsfluktuation ist, umfasst.

53. Verfahren nach Anspruch 51, bei dem der Schritt des Bildens des gechirpten Gitters das Bilden des gechirpten Gitters in der Weise, dass eine Fluktuation der Schrittweite der mehreren Gitterelemente eine periodische Fluktuation ist, umfasst.

54. Halbleiterlasermodul, das umfasst:

   eine Halbleiterlaservorrichtung (51) nach einem der Ansprüche 1 bis 30.

55. Halbleiterlasermodul nach Anspruch 54, das ferner einen internen Isolator (53) umfasst, der zwischen die Halbleiterlaservorrichtung (51) und eine Lichtleitfaser (55) eingesetzt ist, die mit einem Ausgang des Halbleiterlasermoduls gekoppelt ist.

56. Halbleiterlasermodul nach Anspruch 55, das ferner eine Temperatursteuervorrichtung (58) umfasst, die so konfiguriert ist, dass sie eine Isolationseigenschaft des internen Isolators (53) steuert.

**57.** Halbleiterlasermodul nach Anspruch 54, das ferner eine Temperatursteuervorrichtung (58) umfasst, die so konfiguriert ist, dass sie eine Oszillationswellenlänge der Halbleiterlaservorrichtung (51) steuert.

**58.** Halbleiterlasermodul nach Anspruch 57, bei der die Temperatursteuervorrichtung (58) ein Peltier-Modul (58a) umfasst.

**59.** Halbleiterlasermodul nach Anspruch 57, bei der die Temperatursteuervorrichtung (58) einen Thermistor (58a) umfasst.

**60.** Halbleiterlasermodul nach Anspruch 54, das ferner eine polarisationserhaltende Faser (71) umfasst, wobei ein Winkel der Polarisationsachse der polarisationserhaltenden Faser (71) zu dem emittierten Licht von der Halbleiterlaservorrichtung etwa 45 Grad beträgt.

**61.** Lichtleitfaser-Verstärker, der umfasst:

die Halbleiterlaservorrichtung (51) nach einem der Ansprüche 1 bis 30.

**62.** Wellenlängenteilungs-Multiplexierungssystem, das umfasst:

den Lichtleitfaser-Verstärker nach Anspruch 61.

**63.** Raman-Verstärker, der umfasst:

eine Halbleiterlaservorrichtung nach einem der Ansprüche 1 bis 30.

**64.** Raman-Verstärker nach Anspruch 63, bei dem die Halbleiterlaservorrichtung über eine polarisationserhaltende Faser (71) direkt mit einem Wellenlängenteilungs-Multiplexierungskoppler (62) verbunden ist.

**65.** Raman-Verstärker nach Anspruch 69, bei dem ein Winkel der Polarisationsachse der polarisationserhaltenden Faser (71) zu dem emittierten Licht von der Halbleiterlaservorrichtung etwa 45 Grad beträgt.

**Revendications**

**1.** Dispositif à semi-conducteurs comprenant :

une couche active (3) configurée pour rayonner une lumière;
un réseau de diffraction (13),
un revêtement réfléchissant (14) positionné au niveau d'une première extrémité de ladite couche active (3) et sensiblement perpendiculaire par rapport à celle-ci ; et
un revêtement antireflet (15) positionné au niveau d'une seconde extrémité de ladite couche active (3) à l'opposé de ladite première extrémité et sensiblement perpendiculaire par rapport à ladite couche active (3),

dans lequel ledit revêtement réfléchissant (14) et ledit revêtement antireflet (13) définissent une cavité de résonance à l'intérieur de ladite couche active, et dans lequel ledit réseau de diffraction (13) est configuré pour sélectionner une pluralité de modes longitudinaux à l'intérieur d'une largeur spectrale prédéterminée d'un spectre de longueur d'onde d'oscillation du dispositif à semi-conducteurs, **caractérisé en ce qu'**une longueur (L) de ladite cavité de résonance est d'au moins 800 $\mu$m afin de réduire une diffusion de Brillouin stimulée pendant le pompage d'un amplificateur de Raman.

**2.** Dispositif à semi-conducteurs selon la revendication 1, dans lequel une longueur (L) de ladite cavité de résonance n'est pas supérieure à 3200 $\mu$m.

**3.** Dispositif à semi-conducteurs selon la revendication 1, dans lequel ledit réseau de diffraction (13) est sensiblement formé le long d'une longueur entière de ladite couche active (3).

**4.** Dispositif à semi-conducteurs selon la revendication 3, dans lequel ledit réseau de diffraction (13) comprend une pluralité d'éléments de réseau ayant un pas constant.

**5.** Dispositif à semi-conducteurs selon la revendication 3, dans lequel ledit réseau de diffraction (13) comprend un réseau de diffraction dispersé (47) ayant une pluralité d'éléments de réseau ayant des pas variables.

**6.** Dispositif à semi-conducteurs selon la revendication 5, dans lequel ledit réseau de diffraction dispersé est formé de telle sorte qu'une variation du pas de ladite pluralité d'éléments de réseau est une variation aléatoire.

**7.** Dispositif à semi-conducteurs selon la revendication 5, dans lequel ledit réseau de diffraction dispersé (47) est formé de telle sorte qu'une variation du pas de ladite pluralité d'éléments de réseau est une variation périodique.

**8.** Dispositif à semi-conducteurs selon la revendication 1 , dans lequel ledit réseau de diffraction est un réseau de diffraction raccourci (43, 44, 45, 46) formé le long d'une partie d'une longueur entière de ladite couche active.

**9.** Dispositif à semi-conducteurs selon la revendication 8, dans lequel ledit réseau de diffraction (43, 44, 45, 46) comprend une pluralité d'éléments de réseau ayant un pas constant.

10. Dispositif à semi-conducteurs selon la revendication 8, dans lequel ledit réseau de diffraction comprend un réseau de diffraction dispersé (47) ayant une pluralité d'éléments de réseau ayant des pas variables.

11. Dispositif à semi-conducteurs selon la revendication 10, dans lequel ledit réseau de diffraction dispersé (47) est formé de telle sorte qu'une variation du pas de ladite pluralité des éléments de réseau est une variation aléatoire.

12. Dispositif à semi-conducteurs selon la revendication 10, dans lequel ledit réseau de diffraction dispersé (47) est formé de telle sorte qu'une variation du pas de ladite pluralité d'éléments de réseau est une variation périodique.

13. Dispositif à semi-conducteurs selon la revendication 8, dans lequel ledit réseau de diffraction est configuré de façon à établir la largeur spectrale prédéterminée à une valeur non supérieure à 3 nm.

14. Dispositif à semi-conducteurs selon la revendication 8, dans lequel ledit réseau de diffraction raccourci (43, 45) est positionné le long d'une partie de la couche active (3) contiguë par rapport audit revêtement antireflet.

15. Dispositif à semi-conducteurs selon la revendication 14, dans lequel ledit revêtement antireflet (15) a une réflectivité ultra faible d'approximativement 0,1% à 2 %.

16. Dispositif à semi-conducteurs selon la revendication 14, dans lequel ledit revêtement antireflet 15 a une réflectivité ultra faible d'approximativement 0,1 % ou moins.

17. Dispositif à semi-conducteurs selon la revendication 14, dans lequel ledit revêtement réfléchissant (14) a une réflectivité élevée d'au moins 80 %.

18. Dispositif à semi-conducteurs selon la revendication 14, dans lequel ledit réseau de diffraction raccourci (43, 45) a un coefficient de couplage K*Lg d'approximativement 0,3 ou moins.

19. Dispositif à semi-conducteurs selon la revendication 14, dans lequel ledit réseau de diffraction raccourci (43, 45) a un coefficient de couplage K*L d'approximativement 0,1 ou moins.

20. Dispositif à semi-conducteurs selon la revendication 8, dans lequel ledit réseau de diffraction raccourci (44, 46) est positionné le long d'une partie de la couche active contiguë par rapport audit revêtement réfléchissant (14).

21. Dispositif à semi-conducteurs selon la revendication 20, dans lequel ledit revêtement antireflet a une faible réflectivité d'approximativement 1 % à 5 %.

22. Dispositif à semi-conducteurs selon la revendication 20, dans lequel ledit revêtement réfléchissant (14) a une réflectivité ultra faible d'approximativement 0,1% à 2 %.

23. Dispositif à semi-conducteurs selon la revendication 20, dans lequel ledit revêtement réfléchissant (14) a une réflectivité ultra faible d'approximativement 0,1% ou moins.

24. Dispositif à semi-conducteurs selon la revendication 20, dans lequel ledit réseau de diffraction raccourci (44, 46) a un coefficient de couplage K*L d'approximativement 1 ou plus.

25. Dispositif à semi-conducteurs selon la revendication 20, dans lequel ledit réseau de diffraction raccourci (44, 46) a un coefficient de couplage K*L d'approximativement 3 ou plus.

26. Dispositif à semi-conducteurs selon la revendication 8, dans lequel ledit réseau de diffraction raccourci comprend un premier réseau de diffraction raccourci (45) positionné le long d'une partie de la couche active (3) contiguë par rapport audit revêtement antireflet (15), et un second réseau de diffraction raccourci (46) positionné le long d'une partie de la couche active contiguë par rapport audit revêtement réfléchissant (14).

27. Dispositif à semi-conducteurs selon la revendication 26, dans lequel ledit revêtement antireflet (15) et ledit revêtement réfléchissant (14) ont une réflectivité ultra faible d'approximativement 0,1 % à 2 %.

28. Dispositif à semi-conducteurs selon la revendication 26, dans lequel ledit revêtement antireflet (15) et ledit revêtement réfléchissant (14) ont une réflectivité ultra faible d'approximativement 0,1 % ou moins.

29. Dispositif à semi-conducteurs selon la revendication 26, dans lequel ledit premier réseau de diffraction raccourci (45) comprend un premier réseau de diffraction raccourci (45) ayant un coefficient de couplage K*L d'approximativement 0,3 ou moins.

30. Dispositif à semi-conducteurs selon la revendication 26, dans lequel ledit second réseau de diffraction raccourci (46) comprend un second réseau de diffraction raccourci (46) ayant un coefficient de couplage K*L d'approximativement 1 ou plus.

**31.** Procédé destiné à fournir une lumière à partir d'un dispositif laser à semi-conducteurs (20), comprenant les étapes consistant à :

faire rayonner une lumière à partir d'une couche active (3) dudit dispositif laser à semi-conducteurs (20) ;
prévoir un réseau de diffraction (13) à l'intérieur dudit dispositif laser à semi-conducteurs pour sélectionner une partie de ladite lumière rayonnée qui doit être émise par ledit dispositif laser à semi-conducteurs (20) sous la forme d'un faisceau optique de sortie ; et
sélectionner des paramètres physiques dudit dispositif laser à semi-conducteurs (20) de telle sorte que ledit faisceau optique de sortie a un spectre de longueur d'onde d'oscillation ayant une pluralité de modes longitudinaux situés à l'intérieur d'une largeur spectrale prédéterminée (w) du spectre de longueur d'onde d'oscillation,

dans lequel ladite étape consistant à sélectionner les paramètres physiques comprend les étapes consistant à établir une longueur (L) d'une cavité de résonance dudit dispositif laser à semi-conducteurs (20) pour fournir un intervalle de longueur d'onde prédéterminé ($\Delta\lambda$) entre ladite pluralité de modes longitudinaux et établir la longueur (L) de telle sorte que ladite pluralité de modes longitudinaux est fournie à l'intérieur de ladite largeur spectrale prédéterminée (w) du spectre de longueur d'onde d'oscillation,
**caractérisé en ce que** ladite étape consistant à établir la longueur (L) d'une cavité de résonance comprend l'étape consistant à établir la longueur (L) de la cavité à au moins 800 $\mu$m afin de réduire la diffusion de Brillouin stimulée pendant le pompage d'un amplificateur de Raman.

**32.** Procédé selon la revendication 31, dans lequel ladite étape consistant à établir la longueur (L) d'une cavité de résonance comprend l'étape consistant à établir la longueur (L) de telle sorte que l'intervalle de longueur d'onde ($\Delta\lambda$) entre ladite pluralité de modes longitudinaux est d'au moins 0,1 nm.

**33.** Procédé selon la revendication 32, dans lequel ladite étape consistant à établir la longueur (L) de ladite cavité de résonance comprend l'étape consistant à établir la longueur (L) à une valeur non supérieure à 3200 $\mu$m.

**34.** Procédé selon la revendication 31, dans lequel ladite étape consistant à sélectionner des paramètres physiques comprend l'étape consistant à établir une longueur (LG) dudit réseau de diffraction (43, 44, 45, 46) de façon à ce qu'il soit plus court qu'une longueur de ladite couche active pour élargir ainsi ladite largeur spectrale prédéterminée (vv) du spectre de longueur d'onde d'oscillation.

**35.** Procédé selon la revendication 34, comprenant en outre l'étape consistant à positionner ledit réseau de diffraction (43, 45) de façon contiguë à un revêtement antireflet (15) du dispositif laser à semi-conducteurs.

**36.** Procédé selon la revendication 35, comprenant en outre l'étape consistant à établir une réflectivité dudit revêtement antireflet (15) à une valeur d'approximativement 0,1 % à 2 %.

**37.** Procédé selon la revendication 35, comprenant en outre l'étape consistant à établir une réflectivité dudit revêtement antireflet (15) à une valeur d'approximativement 0,1 % ou moins.

**38.** Procédé selon la revendication 35, comprenant en outre l'étape consistant à établir une réflectivité d'un revêtement réfléchissant (14) opposé audit revêtement antireflet (15) à une valeur d'au moins 80 %.

**39.** Procédé selon la revendication 35, comprenant en outre l'étape consistant à établir un coefficient de couplage K*Lg à approximativement 0,3 ou moins.

**40.** Procédé selon la revendication 35, comprenant en outre l'étape consistant à établir un coefficient de couplage K*Lg à approximativement 0,1 ou moins.

**41.** Procédé selon la revendication 34, comprenant en outre l'étape consistant à positionner ledit réseau de diffraction (44, 46) de façon contiguë à un revêtement réfléchissant (14) du dispositif laser à semi-conducteurs.

**42.** Procédé selon la revendication 41, comprenant en outre l'étape consistant à établir une réflectivité dudit revêtement réfléchissant (14) à une valeur comprise approximativement entre 0,1 % et 2 %.

**43.** Procédé selon la revendication 41, comprenant en outre l'étape consistant à établir une réflectivité dudit revêtement réfléchissant (14) à une valeur d'approximativement 0,1 % ou moins.

**44.** Procédé selon la revendication 41, comprenant en outre l'étape consistant à établir une réflectivité d'un revêtement antireflet (15) opposé audit revêtement réfléchissant (14) à une valeur approximativement comprise entre 1 % et 5 %.

**45.** Procédé selon la revendication 41, comprenant en outre l'étape consistant à établir un coefficient de couplage K*Lg à approximativement 1 ou plus.

**46.** Procédé selon la revendication 41, comprenant en outre l'étape consistant à établir un coefficient de couplage K *Lg à approximativement 3 ou plus.

**47.** Procédé selon la revendication 34, comprenant en outre l'étape consistant à positionner ledit réseau de diffraction comme un premier réseau de diffraction raccourci (45) contiguë par rapport à un revêtement antireflet (15) du dispositif laser à semi-conducteurs et un second réseau de diffraction raccourci (46) contigu par rapport à un revêtement réfléchissant (14) opposé audit revêtement antireflet (15).

**48.** Procédé selon la revendication 47, comprenant en outre l'étape consistant à établir une réflectivité dudit revêtement antireflet et dudit revêtement réfléchissant à une valeur approximativement comprise entre 0,1 % et 2 %.

**49.** Procédé selon la revendication 47, comprenant en outre l'étape consistant à établir une réflectivité dudit revêtement antireflet et dudit revêtement réfléchissant à une valeur d'approximativement 0,1 % ou moins.

**50.** Procédé selon la revendication 47, comprenant en outre l'étape consistant à établir respectivement un coefficient de couplage K*Lg desdits premier et second réseaux de diffraction (45, 46) à approximativement 0,3 ou moins, et approximativement 1 ou plus.

**51.** Procédé selon la revendication 31, dans lequel ladite étape consistant à sélectionner des paramètres physiques comprend l'étape consistant à former ledit réseau de diffraction (13) tel un réseau de diffraction dispersé ayant une pluralité d'éléments de réseau ayant des pas variables pour élargir ainsi ladite largeur spectrale prédéterminée (w) du spectre de longueur d'onde d'oscillation.

**52.** Procédé selon la revendication 51, dans lequel ladite étape consistant à former ledit réseau de diffraction dispersé comprend l'étape consistant à former le réseau de diffraction dispersé de telle sorte qu'une variation du pas de ladite pluralité d'éléments de réseau est une variation aléatoire.

**53.** Procédé selon la revendication 51, dans lequel ladite étape consistant à former ledit réseau de diffraction dispersé comprend l'étape consistant à former le réseau de diffraction dispersé de telle sorte qu'une variation du pas de ladite pluralité d'éléments de réseau est une variation périodique.

**54.** Module laser à semi-conducteurs comprenant :

le dispositif laser à semi-conducteurs (51) selon l'une quelconque des revendications 1 à 30.

**55.** Module laser à semi-conducteurs selon la revendication 54, comprenant en outre un isolateur interne (53) intercalé entre ledit dispositif laser à semi-conducteurs (51) et une fibre optique (55) couplée à une sortie dudit module laser à semi-conducteurs.

**56.** Module laser à semi-conducteurs selon la revendication 55, comprenant en outre un dispositif de commande de température (58) configuré pour commander une caractéristique d'isolation dudit isolateur interne (53).

**57.** Module laser à semi-conducteurs (54), comprenant en outre un dispositif de commande de température (58) configuré pour commander une longueur d'onde d'oscillation dudit dispositif laser à semi-conducteurs (51).

**58.** Module laser à semi-conducteurs selon la revendication 57, dans lequel ledit dispositif de commande de température (58) comprend un module de Peltier (58a).

**59.** Module laser à semi-conducteurs selon la revendication 57, dans lequel ledit dispositif de commande de température (58) comprend une thermistance (58a).

**60.** Module laser à semi-conducteurs selon la revendication 54, comprenant en outre une fibre de maintien de polarisation (71), dans lequel un angle de l'axe de polarisation de la fibre de maintien de polarisation (71) par rapport à la lumière émise par le dispositif laser à semi-conducteurs est d'approximativement 45 degrés.

**61.** Amplificateur de fibre optique comprenant :

le dispositif laser à semi-conducteurs (51) selon l'une quelconque des revendications 1 à 30.

**62.** Système de multiplexage par répartition en longueurs d'ondes comprenant:

l'amplificateur de fibre optique selon la revendication 61.

**63.** Amplificateur de Raman comprenant :

un dispositif laser à semi-conducteurs selon l'une quelconque des revendications 1 à 30.

**64.** Amplificateur de Raman selon la revendication 63, dans lequel ledit dispositif laser à semi-conducteurs est directement connecté à un dispositif de couplage à multiplexage par répartition en longueurs d'ondes (62) par l'intermédiaire d'une fibre de maintien de polarisation (71).

65. Amplificateur de Raman selon la revendication 64, dans lequel un angle de l'axe de polarisation de la fibre de maintien de polarisation (71) par rapport à une lumière émise par ledit dispositif laser à semi-conducteurs est d'approximativement 45 degrés.

FIGURE 1

FIGURE 2

**FIGURE 3**

FIGURE 4

$$3200 \, \mu\text{m} \geq L \geq 800 \, \mu\text{m}$$

FIGURE 5

FIGURE 5A

FIGURE 6

FIGURE 7

FIGURE 8

FIGURE 9

FIGURE 10

11A

$\Lambda 2$ $\Lambda 1$ $\Lambda 2$ $\Lambda 1$ $\Lambda 2$

...

11B

$\Lambda 1$ $\Lambda 2$ $\Lambda 1$

...

11C

$\Lambda 1$ $\Lambda 2$

...

FIGURE 11

**FIGURE 12**

FIGURE 13

EP 1 202 407 B1

EP 1 202 407 B1

FIGURE 14

EP 1 202 407 B1

FIGURE 15B

FIGURE 15A

# FIGURE 16

EP 1 202 407 B1

FIGURE 17